# EUROPEAN PATENT SPECIFICATION

(11) **EP 4 611 513 B1**
(45) Date of publication and mention of the grant of the patent: **08.07.2026**
(21) Application number: 24223448.2
(22) Date of filing: 27.12.2024
(51) Int. Cl.: H10K 59/121, H10K 59/123, H10K 59/131, H10K 59/80, H10K 71/00

(54) **TRANSPARENT DISPLAY DEVICE**
TRANSPARENTE ANZEIGEVORRICHTUNG
DISPOSITIF D'AFFICHAGE TRANSPARENT

(30) Priority: 27.02.2024 KR 20240027951
(43) Date of publication of application: 03.09.2025
(73) Proprietor: LG Display Co., Ltd., Seoul, 07336 (KR)
(72) Inventor: KIM, Euijun, Gyeonggi-do 10845 (KR)
(74) Representative: Ter Meer Steinmeister & Partner

(56) References cited:
- EP-B1- 4 020 581
- US-A1- 2023 172 008

## Description

### BACKGROUND

### Technical Field

The present disclosure relates to a transparent display device and a transparent display panel, and more particularly, for example, without limitation, to a transparent display device and a transparent display panel capable of reducing an extend of a light emitting area being darkened.

### Description of the Related art

Recently, research has been actively conducted on a transparent display device in which a user can view an object or an image located on a rear surface of a display device. The transparent display device can include a transmissive area through which a display area on which an image is displayed can transmit external light and can have a high light transmittance in the display area through the transmissive area.

Meanwhile, a plurality of subpixels including a circuit device and a light emitting device can be disposed in a non-transmissive area.

The description provided in the description of the related art section should not be assumed to be prior art merely because it is mentioned in or associated with the description of the related art section. The description of the related art section may include information that describes one or more aspects of the subject technology, and the description in this section does not limit the invention.
EP 4020581 B1 describes a transparent display device that comprises a plurality of first signal lines extended in a first direction and spaced apart from each other, a plurality of second signal lines extended in a second direction and spaced apart from each other, a transmissive area provided between two adjacent first signal lines and between two adjacent second signal lines, a pixel including a plurality of subpixels disposed based on an intersection area where a first signal line and a second signal line cross each other, a first electrode provided in each of the plurality of subpixels, including a first side and a second side, which are disposed to be adjacent to the transmissive area and have an inclination with respect to each of the first signal line and the second signal line, a circuit area connected with the first electrode through a contact hole disposed to be adjacent to the first side of the first electrode, and an anode line extended from the second side of the first electrode of each of the plurality of subpixels and at least partially overlapped with a circuit area of an adjacent subpixel of the same color.
US 2023/0172008 A1 describes a transparent display device that comprises a plurality of transmissive areas, and a plurality of subpixels disposed between the plurality of transmissive areas. Each of the plurality of subpixels includes a driving transistor including an active layer, a gate electrode, a source electrode and a drain electrode, a light emitting element including a first electrode, a light emitting layer and a second electrode, and a conductive organic layer provided between the driving transistor and the first electrode of the light emitting element to electrically connect the driving transistor with the first electrode. The first electrode includes a first electrode portion and a second electrode portion, and the conductive organic layer is electrically connected to the first electrode portion through a first contact hole and is electrically connected to the second electrode portion through a second contact hole.

### SUMMARY

The inventors have recognized that, a defect can occur in the light emitting device, e.g. due to moisture or oxygen permeating from the outside, whereby the plurality of subpixels can become darkened. Since the transparent display device has the transmissive area, an extent of the light emitting area is smaller than that of the general display device, such that the defective subpixel in which the darkening occurs can be easily recognized by a user.

Accordingly, the present disclosure has been made in view of the above problems, and it is an object of the present disclosure to provide a transparent display device capable of reducing an extend of a light emitting area being darkened.

It is another object of the present disclosure to provide a transparent display device capable of minimizing reduction of light transmittance by an anode connection line for connecting divided anode electrodes.

It is a further object of the present disclosure to provide a transparent display device capable of implementing ESG (Environment/Social/Governance) by reducing a generation of greenhouse gas which can occur due to a manufacturing process.

The object is solved by the features of the independent claim.

Preferred embodiments are given in the dependent claims.

In one or more embodiments, the driving transistor may include an active layer, a gate electrode, a source electrode, and a drain electrode.

In one or more embodiments, the anode connection line may be formed of a material whose oxidation degree is lower than that of each of the gate electrode, the source electrode, and the drain electrode of the driving transistor.

In one or more embodiments, only one pixel may be disposed between the first transmissive area and the second transmissive area.

In one or more embodiments, the anode connection line may be electrically connected to the driving transistor through a first contact hole.

In one or more embodiments, the anode connection line may include a first anode connection line extending from the first contact hole toward the first transmissive area and connected to the first anode electrode at its one end, and a second anode connection line extending from the first contact hole toward the second transmissive area and connected to the second anode electrode at its one end.

In one or more embodiments, the first anode connection line may be electrically connected to the first anode electrode through a second contact hole at its one end.

In one or more embodiments, the second anode connection line may be electrically connected to the second anode electrode through a third contact hole at its one end.

In one or more embodiments, the driving transistor may be disposed between the second contact hole and the third contact hole.

In one or more embodiments, the first anode connection line and the second anode connection line may be disposed on the same layer.

In one or more embodiments, at least a portion of the first anode connection line may overlap the first anode electrode between the first transmissive area and the driving transistor.

In one or more embodiments, at least a portion of the second anode connection line may overlap the second anode electrode between the second transmissive area and the driving transistor.

In one or more embodiments, the first anode connection line is provided with a first cutting area in a region being not overlapped with the first anode electrode.

In one or more embodiments, the second anode connection line may be provided with a second cutting area in a region being not overlapped with the second anode electrode.

In one or more embodiments, the first cutting area may be cut by using laser when a defect occurs in the first anode electrode, and the second cutting area may be cut by using laser when a defect occurs in the second anode electrode.

In one or more embodiments, the first anode connection line may have a plurality of first cutting areas and the second anode connection line has a plurality of second cutting areas.

In one or more embodiments, the first cutting area for the first anode connection line may be disposed in the first transmissive area.

In one or more embodiments, the second cutting area for the second anode connection line may be disposed in the second transmissive area.

In one or more embodiments, the driving transistor may include an active layer, a gate electrode, a source electrode, and a drain electrode.

In one or more embodiments, the anode connection line may be electrically connected to one of the source electrode and the drain electrode of the driving transistor through the first contact hole.

In one or more embodiments, the first contact hole may not be overlapped with the active layer of the driving transistor.

In one or more embodiments, the transparent display device may further comprise a capacitor including a first capacitor electrode provided on the same layer as the active layer of the driving transistor and a second capacitor electrode provided on the same layer as the gate electrode of the driving transistor.

In one or more embodiments, the first contact hole may not be overlapped with the first capacitor electrode of the capacitor.

In one or more embodiments, a thickness of the anode connection line may be thinner than a thickness of each of the gate electrode, the source electrode, and the drain electrode of the driving transistor.

In one or more embodiments, the anode connection line may include molybdenum and titanium.

In one or more embodiments, the anode connection line may be disposed on the driving transistor.

In one or more embodiments, the first anode electrode may include a first protrusion protruding toward the first transmissive area.

In one or more embodiments, the second anode electrode may include a second protrusion protruding toward the second transmissive area.

In one or more embodiments, the anode connection line may include a first anode connection line connected to the first protrusion of the first anode electrode through a second contact hole and the second anode connection line connected to the second protrusion of the second anode electrode through a third contact hole.

The anode connection line extends across the non-transmissive area from the first transmissive area to the second transmissive area.

In one or more embodiments, the plurality of signal lines may include at least one of a plurality of data lines disposed on one side of the driving transistor; a power line disposed on the other side of the driving transistor; and a reference line disposed on the other side of the driving transistor.

In one or more embodiments, the transparent display device may further comprise a scan line extending in the first direction in the non-transmissive area.

In one or more embodiments, the first anode electrode and the second anode electrode may be disposed adjacent to each other in the first direction.

In one or more embodiments, the first anode electrode and the second anode electrode may be electrically connected to the same driving transistor through the anode connection line.

In one or more embodiments, one side of the first anode electrode may be disposed adjacent to one transmissive area and the first anode electrode may include a first protrusion protruding from the one side of the first anode electrode toward the one transmissive area.

In one or more embodiments, one side of the second anode electrode may be disposed adjacent to the other transmissive area and the second anode electrode may include a second protrusion protruding from the one side of the second anode electrode toward the other transmissive area.

In one or more embodiments, the plurality of signal lines may be disposed between the first protrusion of the first anode electrode and the second protrusion of the second anode electrode.

In one or more embodiments, one end of the anode connection line may be connected to the first protrusion of the first anode electrode through a second contact hole.

In one or more embodiments, the other end of the anode connection line may be connected to the second protrusion of the second anode electrode through a third contact hole.

The anode connection line extends across the non-transmissive area from the one transmissive area to the other transmissive area.

It is to be understood that both the foregoing general description and the following detailed description are example and explanatory, and are intended to provide further explanation of the inventive concepts as claimed.

In addition to the effects of the present disclosure as mentioned above, additional advantages and features of the present disclosure will be clearly understood by those skilled in the art from the above description of the present disclosure.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a plan view schematically illustrating a transparent display device according to an example embodiment of the present disclosure;
FIG. 2 illustrates an example of a pixel provided in a region A of FIG. 1;
FIG. 3 is a circuit diagram illustrating an example of a subpixel of FIG. 2;
FIG. 4 illustrates an example of a plurality of subpixels and a plurality of signal lines provided in a region A of FIGs. 1 and 2;
FIG. 5 is an enlarged view illustrating an example of an anode connection line;
FIG. 6 is a cross-sectional view illustrating an example along line I-I' in FIG. 5;
FIG. 7 is a cross-sectional view illustrating an example along line II-II' in FIG. 5;
FIG. 8 illustrates an example in which a cathode electrode and an encapsulation layer are damaged by a laser-cutting process; and
FIG. 9 illustrates an example in which a defect such as a bright spot occurs when the first contact hole overlaps the active layer of the driving transistor or the second capacitor electrode.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF THE DISCLOSURE

Reference will now be made in detail to embodiments of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and features of the present disclosure, and implementation methods thereof will be clarified through following example embodiments described with reference to the accompanying drawings. The present disclosure can, however, be embodied in different forms and should not be construed as limited to the example embodiments set forth herein. Rather, these example embodiments are provided so that this disclosure will be thorough and complete, and will fully convey the scope of the present disclosure to those skilled in the art. Further, the present disclosure is only defined by scopes of claims.

A shape, a size, a ratio, an angle, and a number disclosed in the drawings for describing example embodiments of the present disclosure are merely an example, and thus, the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted. In a case where "include," "have," "comprise," "contain," "constitute," "make up of," "formed of," and "consist of" described in the present specification are used, another part can be added unless 'only~' is used. The terms of a singular form can include plural forms unless referred to the contrary.

The shapes, sizes, dimensions (e.g., length, width, height, thickness, radius, diameter, area, etc.), ratios, angles, numbers of elements, and the like illustrated in the accompanying drawings for describing the example embodiments of the present disclosure are merely examples, and the present disclosure is not limited thereto. Like reference numerals generally denote like elements throughout the specification.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

In construing an element, the element is construed as including an error range although there is no explicit description.

In describing a position relationship, for example, when a position relation between two parts is described as "on", "above", "over", "below", "under", "beside", "beneath", "near", "close to," "adjacent to", "on a side of", "next", one or more other parts can be disposed between the two parts unless 'just' or 'direct' is used.

Spatially relative terms, such as "under," "below," "beneath", "lower," "over," "upper" and the like, may be used herein for ease of description to describe one element or feature's relationship to another element(s) or feature(s) as illustrated in the figures. It will be understood that the spatially relative terms can encompass different orientations of an element in use or operation in addition to the orientation depicted in the figures. For example, if an element in the figures is inverted, elements described as "below" or "beneath" other elements or features would then be oriented "over" the other elements or features. Thus, the example term "below" can encompass both an orientation of below and above. Similarly, the example term "above" or "over" can encompass both an orientation of "above" and "below".

When an element or layer is disposed "on" another element or layer, another layer or another element may be interposed directly on the other element or therebetween.

In describing a time relationship, for example, when the temporal order is described as 'after~', 'subsequent~', 'next~', and 'before~', a case which is not continuous can be included unless 'just' or 'direct' is used.

It will be understood that, although the terms "first", "second", "A", "B", "(A)", or "(B)" etc. can be used herein to describe various elements, these elements should not be limited by these terms. These terms are only used to distinguish one element from another. Accordingly, a first element mentioned hereinafter could be termed a second element without departing from the scope of the present disclosure.

The term "at least one" should be understood as including any and all combinations of one or more of the associated listed items. For example, the meaning of "at least one of a first item, a second item, and a third item" denotes each of the first item, the second item, and the third item as well as the combination of all items proposed from two or more of the first item, the second item, and the third item.

A term "device" used herein may refer to a display device including a display panel and a driver for driving the display panel. Examples of the display device may include a light emitting element, and the like. In addition, examples of the device may include a notebook computer, a television, a computer monitor, an automotive device, a wearable device, and an automotive equipment device, and a set electronic device (or apparatus) or a set device (or apparatus), for example, a mobile electronic device such as a smartphone or an electronic pad, which are complete products or final products respectively including light emitting element and the like, but embodiments of the present disclosure are not limited thereto.

Features of various example embodiments of the present disclosure can be partially or overall coupled to or combined with each other and can be variously inter-operated or combined with each other and driven technically as those skilled in the art can sufficiently understand. The example embodiments of the present disclosure can be carried out independently from each other, or can be carried out together in co-dependent relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein.

In the aspects of the present disclosure, a source electrode and a drain electrode are distinguished from each other, for convenience of description. However, the source electrode and the drain electrode are used interchangeably. The source electrode may be the drain electrode, and the drain electrode may be the source electrode. Also, the source electrode in any one aspect of the present disclosure may be the drain electrode in another aspect of the present disclosure, and the drain electrode in any one aspect of the present disclosure may be the source electrode in another aspect of the present disclosure.

Hereinafter, examples of transparent display device according to the present disclosure will be described in detail with reference to the accompanying drawings. In assigning reference numerals to the components in each drawing, the same component can have the same numeral as far as possible, even if shown in different drawings. In addition, in describing the present disclosure, specific descriptions of related disclosed configurations or features can be omitted if it is determined that such detailed description would obscure the concept of the present disclosure.

Hereinafter, example embodiments of the present disclosure will be described in detail with reference to the accompanying drawings.

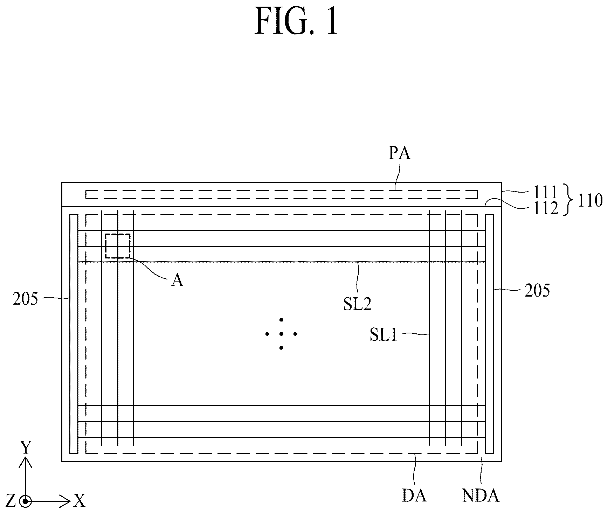

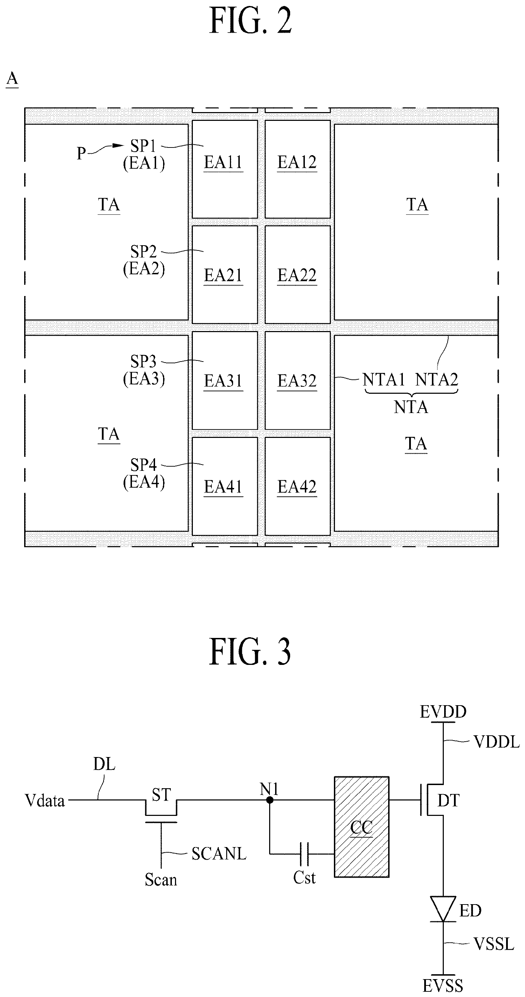

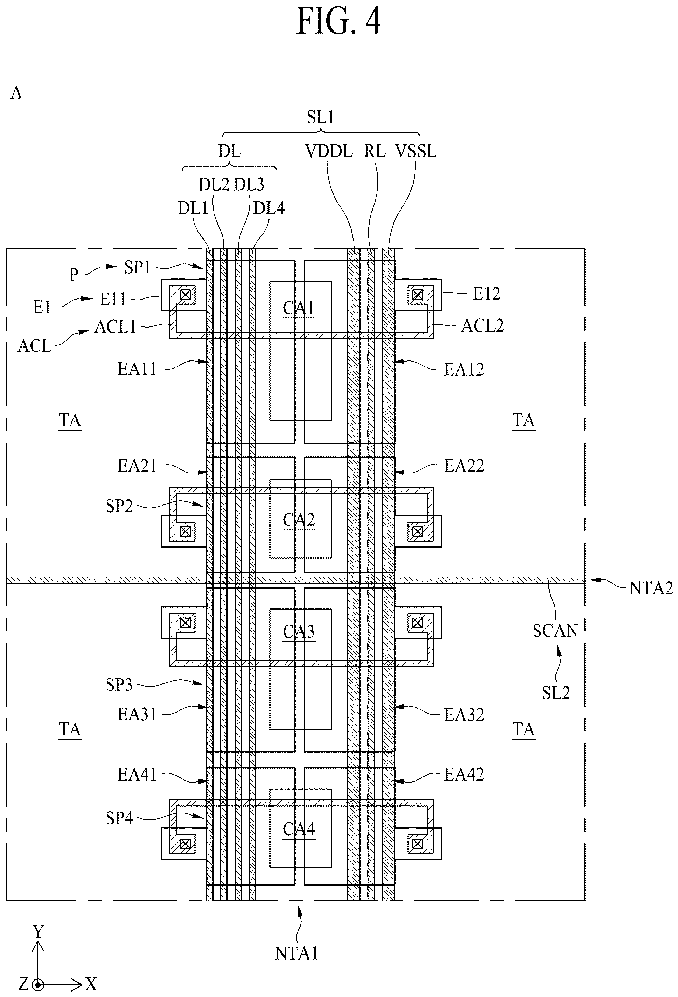

FIG. 1 is a plan view schematically illustrating a transparent display device according to an example embodiment of the present disclosure. FIG. 2 illustrates an example of a pixel provided in a region A of FIG. 1. FIG. 3 is a circuit diagram illustrating an example of a subpixel of FIG. 2. FIG. 4 illustrates an example of a plurality of subpixels and a plurality of signal lines provided in a region A of FIGs. 1 and 2.

Hereinafter, an X-axis represents a direction parallel to a scan line, a Y-axis represents a direction parallel to a data line, and a Z-axis represents a height direction of a transparent display device 100. However, the present disclosure is not limited thereto, for example, Y-axis may represent a direction parallel with a gate line, X-axis may represent a direction parallel with a data line, and Z-axis may represent a height direction of a transparent display device 100.

Although the transparent display device 100 according to an example embodiment of the present disclosure has been described as an organic light emitting display device, it can be implemented as a liquid crystal display LCD device, a plasma display panel PDP device, quantum dot light emitting display QLED device, or an electrophoresis display device.

Referring to FIG. 1, the transparent display device 100 according to an example embodiment of the present disclosure includes a transparent display panel 110.

The transparent display panel 110 includes a first substrate 111 and a second substrate 112 confronting each other. In other words, the first and second substrate 111, 112 overlap at least partly. The first substrate 111 is large in size than the second substrate 112. The first substrate 111 is at least in one dimension larger than the second substrate 112. The second substrate 112 can be an encapsulation substrate. The first substrate 111 can be a plastic film, a glass substrate, or a silicon wafer substrate formed using a semiconductor process. The second substrate 112 can be a plastic film, a glass substrate, or an encapsulation film. The first substrate 111 and the second substrate 112 can be formed of a transparent material.

The transparent display panel 110 can be divided into a display area DA in which pixels P are formed to display an image and a non-display area NDA which does not display an image. The non-display area NDA may be an area adjacent to the display area DA. Further, the non-display area NDA may be an area disposed adjacent to the display area DA and configured to surround the display area DA. However, the present disclosure is not limited thereto.

For example, the non-display area NDA may include a first non-display area located outside the display area DA in a first direction, a second non-display area located outside the display area DA in a second direction intersecting the first direction, a third non-display area located outside the display area DA in the opposite direction to the first direction, and a fourth non-display area located outside the display area DA in the direction opposite to the second direction.

For another example, a boundary area between the display area DA and the non-display area NDA may be bent so that the non-display area NDA may be located below the display area. In this case, when the user looks at the display device from the front, there may be little or no non-display area NDA visible to the user.

In the non-display area NDA, there can be a pad area PA in which pads are disposed and at least one scan driver 205. The plurality of pads can be disposed in the pad area PA. Since the size of the first substrate 111 is larger than the size of the second substrate 112, a portion of the first substrate 111 can be exposed without being covered by the second substrate 112. The pads such as power pads and data pads can be provided on the portion of the first substrate 111 exposed without being covered by the second substrate 112.

The scan driver 205 can be formed as a gate driver in panel GIP manner in the non-display area NDA on one side or both sides of the display area DA. Alternatively, the scan driver 205 can be manufactured as a driving chip and can be mounted on a flexible film and can be attached to the non-display area NDA on one side or both sides of the display area DA in a tape automated bonding TAB manner.

The display area DA can be provided with first signal lines SL1, second signal lines SL2, and pixels P. The first signal lines SL1 can extend in a second direction (eg, Y-axis direction) in the display area DA. For example, the first signal lines SL1 can be data lines, but not limited thereto. The first signal lines SL1 can include at least one among a first power line, a second power line, and a reference line.

The second signal lines SL2 can extend in a first direction (eg, X-axis direction) in the display area DA, and can intersect the first signal lines SL1 in the display area DA. For example, the second signal lines SL2 can scan lines, but not limited thereto.

As shown in FIG. 2, the pixels P are provided in a region where the first signal line SL1 is provided or a region where the first signal line SL1 and the second signal line SL2 intersect each other and emit predetermined light to display an image.

Each of the plurality of subpixels SP is a minimum unit which configures the display area and n subpixels SP form one pixel. Each of the plurality of subpixels SP may emit light having different wavelengths from each other. The plurality of subpixels may include first to third subpixels which emit different color light from each other. For example, the plurality of subpixels SP may include red subpixels SP, green subpixels SP, and blue subpixels SP. According to the example embodiment, at least some of the plurality of pixels may further include white subpixels SP. The plurality of subpixels SP may be variously modified in colors and configurations, as necessary. However, the present disclosure is not limited thereto.

For example, the plurality of subpixels SP may include red, green, and blue subpixels, in which the red, green, and blue subpixels may be disposed in a repeated manner. Alternatively, the plurality of subpixels SP may include red, green, blue, and white subpixels, in which the red, green, blue, and white subpixels may be disposed in a repeated manner, or the red, green, blue, and white subpixels may be disposed in a quad type. For example, the red sub pixel, the blue sub pixel, and the green sub pixel may be sequentially disposed along a row direction, or the red sub pixel, the blue sub pixel, the green sub pixel and the white sub pixel may be sequentially disposed along the row direction. However, in the embodiment of the present disclosure, the color type, disposition type, and disposition order of the subpixels are not limiting, and may be configured in various forms according to light-emitting characteristics, device lifespans, and device specifications.

Meanwhile, the subpixels may have different light-emitting areas according to light-emitting characteristics. For example, a sub-pixel that emits light of a color different from that of a blue sub-pixel may have a different light-emitting area from that of the blue sub-pixel. For example, the red sub-pixel, the blue sub-pixel, and the green sub-pixel, or the red sub-pixel, the blue sub-pixel, the white sub-pixel, and the green sub-pixel may each has a different light-emitting area.

In detail, the display area DA can include a first area NTA in which a plurality of subpixels SP1, SP2, SP3, and SP4 are disposed, and a second area TA in which a plurality of subpixels SP1, SP2, SP3, and SP4 are not disposed. The first area NTA can be a non-transmissive area which does not transmit most of the light incident from the outside. The second area TA can be a transmissive area through which most of light incident from the outside passes. For example, the transmissive area TA can be an area in which the light transmittance is greater than α%, and the non-transmissive area NTA can be an area in which the light transmittance is less than β%. Herein, 'α' can be a value greater than 'β'. The transparent display panel 110 can view an object or a background located on a rear surface (or back surface) of the transparent display panel 110 through transmissive areas TA.

The non-transmissive area NTA can include a first non-transmissive area NTA1, a second non-transmissive area NTA2, and the pixel P.

The first non-transmissive area NTA1 can extend in the second direction (eg, Y-axis direction) in the display area DA. The first non-transmissive area NTA1 can extend in the second direction (eg, Y-axis direction) between the two transmissive areas TA adjacent in the first direction (eg, X-axis direction). The first non-transmissive area NTA1 can be disposed to overlap at least a portion some of emission areas EA1, EA2, EA3, and EA4.

The transparent display panel 110 can be provided with the plurality of first non-transmissive areas NTA1 spaced apart from each other, and the transmissive area between the adjacent two of the first non-transmissive areas NTA1. In each first non-transmissive area NTA1, the plurality of first signal lines SL1 extending in the second direction (eg, Y-axis direction) can be spaced apart from each other.

As shown in FIG. 4, the first signal lines SL1 can include at least one of the first power line VDDL, the reference line REFL, the data lines DL1, DL2, DL3, and DL4, and the second power line VSSL.

The first power line VDDL can supply a first power to a driving transistor of each of the subpixels SP1, SP2, SP3, and SP4 included in the display area DA. The second power line VSSL can supply a second power to a second electrode of each of the subpixels SP1, SP2, SP3, and SP4 included in the display area DA. In this case, the second power source can be a common power source commonly supplied to the subpixels SP1, SP2, SP3, and SP4.

The reference line REFL can supply an initialization voltage (or reference voltage) to the driving transistor of each of the subpixels SP1, SP2, SP3, and SP4 included in the display area DA. Each of the data lines DL1, DL2, DL3, and DL4 can supply a data voltage to the subpixels SP1, SP2, SP3, and SP4.

In the transparent display panel 110 according to an example embodiment of the present disclosure, the pixel P is provided between the adjacent transmissive areas TA, and the pixel P can include the emission areas EA1, EA2, EA3, and EA4 in which light emitting devices are disposed to emit light. In the transparent display panel 110, the non-transmissive area NTA has a small-sized area, whereby a circuit device including a transistor, a capacitor, and the like can be disposed to overlap the emission area EA1, EA2, EA3, and EA4. That is, the emission area EA1, EA2, EA3, and EA4 can at least partially overlap a circuit area CA1, CA2, CA3, and CA4 in which the circuit device is disposed.

For example, the circuit area can include a first circuit area CA1 in which the circuit device connected to the first subpixel SP1 is disposed, a second circuit area CA2 in which the circuit device connected to the second subpixel SP2 is disposed, a third circuit area CA3 in which the circuit device connected to the third subpixel SP3 is disposed, and a fourth circuit area CA4 in which the circuit device connected to the fourth subpixel SP4 is disposed.

The circuit area CA1, CA2, CA3, and CA4 can be disposed between the plurality of first signal lines SL1. For example, the plurality of data lines DL can be disposed at one side of the circuit device including the transistor, the capacitor, and the like, and the first and second power lines VDDL and VSSL and the reference line RL can be disposed on the other side of the circuit device. The reference line RL can be spaced apart from the plurality of data lines DL by a predetermined distance through the use of circuit device including the capacitor or the like. Alternatively, when the reference line RL is disposed between the plurality of data lines DL, the reference line RL can have a parasitic capacitance which occurs between the reference line RL and the plurality of data lines DL. Since a data signal applied to the plurality of data lines DL is highly variable, a ripple phenomenon in which the initialization voltage (or reference voltage) shakes due to the data signal applied to the plurality of data lines DL can occur in the reference line RL.

In the transparent display panel 110 according to an example embodiment of the present disclosure, the reference line RL and the plurality of data lines DL can be spaced apart from each other with the circuit device including the transistor, the capacitor, and the like interposed therebetween. Meanwhile, in the transparent display panel 110 according to an example embodiment of the present disclosure, the reference line RL together with the first and second power lines VDDL and VSSL can be disposed on the other side of the circuit device. A constant voltage is applied to each of the first and second power lines VDDL and VSSL. Thus, even if the reference line RL is disposed adjacent to the first and second power lines VDDL and VSSL, the initialization voltage (or reference voltage) can be stably supplied without the ripple phenomenon.

The second non-transmissive area NTA2 can extend in the first direction (eg, X-axis direction) in the display area DA. The second non-transmissive area NTA2 can extend in the first direction (eg, X-axis direction) between the two transmissive areas TA adjacent in the second direction (eg, Y-axis direction). The second non-transmissive area NTA2 can be disposed such that at least a portion of the second non-transmissive area NTA2 overlaps the emission areas EA1, EA2, EA3, and EA4.

The transparent display panel 110 can include the plurality of second non-transmissive areas NTA2 spaced apart from each other, and the transmissive area TA can be provided between the two adjacent second non-transmissive areas NTA2. The second signal line SL2 can be disposed in the second non-transmissive area NTA2.

The second signal line SL2 can extend in the first direction (eg, X-axis direction). For example, the second signal line SL2 can include a scan line SCANL. The scan line SCANL can supply a scan signal to the subpixels SP1, SP2, SP3, and SP4 of the pixel P.

Each of the pixels P can be provided in the first non-transmissive area NTA1, and can emit light to display an image. The emission area EA can correspond to an area in which light is emitted from the pixel P.

As shown in FIGS. 2 and 4, each of the pixels P can include the first subpixel SP1, the second subpixel SP2, the third subpixel SP3, and the fourth subpixel SP4. The first subpixel SP1 can include a first emission area EA1 for emitting first color light, and the second subpixel SP2 can include a second emission area EA2 for emitting second color light. The third subpixel SP3 can include a third emission area EA3 for emitting third color light, and the fourth subpixel SP4 can include a fourth emission area EA4 for emitting fourth color light.

For example, all the first to fourth emission areas EA1, EA2, EA3, and EA4 can emit light of different colors. For example, the first emission area EA1 can emit red light, and the second emission area EA2 can emit green light. The third emission area EA3 can emit blue light, and the fourth emission area EA4 can emit white light. However, the present disclosure is not necessarily limited thereto. In addition, the arrangement order of the subpixels SP1, SP2, SP3, and SP4 can be variously changed.

Meanwhile, the emission areas EA1, EA2, EA3, and EA4 included in the plurality of subpixels SP1, SP2, SP3, and SP4 can include a plurality of divided emission areas. In detail, the first emission area EA1 included in the first subpixel SP1 can include a first sub-emission area EA11 and a second sub-emission area EA12 divided into the two. The second emission area EA2 included in the second subpixel SP2 can include a first sub-emission area EA21 and a second sub-emission area EA22 divided into the two. The third emission area EA3 included in the third subpixel SP3 can include a first sub-emission area EA31 and a second sub-emission area EA32 divided into the two. The fourth emission area EA4 included in the fourth subpixel SP4 can include a first sub-emission area EA41 and a second sub-emission area EA42 divided into the two. However, the present disclosure is not limited thereto, the light emission areas EA1, EA2, EA3 and EA4 respectively provided in the plurality of subpixels SP1, SP2, SP3 and SP4 can include a plurality of light emission areas divided into more than two, for example, the first light emission area EA1 provided in the first subpixel SP1 can include a first sub-light emission area, a second sub-light emission area and a third sub-light emission area, which are divided into three. The second light emission area EA2 provided in the second subpixel SP2 can include a first sub-light emission area, a second sub-light emission area and a third sub-light emission area, which are divided into three. The third light emission area EA3 provided in the third subpixel SP3 can include a first sub-light emission area, a second sub-light emission area and a third sub-light emission area, which are divided into three. The fourth light emission area EA4 provided in the fourth subpixel SP4 can include a first sub-light emission area, a second sub-light emission area and a third sub-light emission area, which are divided into three.

As described above, when each of the subpixels SP1, SP2, SP3, and SP4 is turned-on by the scan signal of the scan line SCANL, the data voltage of the data line DL is supplied to a gate electrode of the driving transistor, whereby the light emitting device can emit light according to a drain-to-source current of the driving transistor.

Referring to FIG. 3, each of the subpixels SP1, SP2, SP3, and SP4 can have 2T(Transistor)1C(Capacitor) structure including two transistors DT and ST and one capacitor Cst, but not limited thereto. Each of the subpixels SP1, SP2, SP3, and SP4 can further include a compensation circuit CC. In this case, various structures such as 4T2C, 5T2C, 6T1C, 6T2C, 7T1C, 7T2C, and the like can be provided.

The transistors may be thin-film transistors TFTs. Active layers of thin-film transistors TFTs may be formed of a semiconductor material, such as an oxide semiconductor, amorphous semiconductor, or polycrystalline semiconductor, but is not limited thereto.

The oxide semiconductor material may have an excellent effect of preventing a leakage current and relatively inexpensive manufacturing cost. The oxide semiconductor may be made of a metal oxide such as zinc (Zn), indium (In), gallium (Ga), tin (Sn), and titanium (Ti) or a combination of a metal such as zinc (Zn), indium (In), gallium (Ga), tin (Sn), or titanium (Ti) and its oxide. Specifically, the oxide semiconductor may include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), indium zinc oxide (IZO), indium gallium tin oxide (IGTO), and indium gallium oxide (IGO), but is not limited thereto.

The polycrystalline semiconductor material has a fast movement speed of carriers such as electrons and holes and thus has high mobility, and has low energy power consumption and superior reliability. The polycrystalline semiconductor may be made of polycrystalline silicon (poly-Si), but is not limited thereto.

The amorphous semiconductor material may be made of amorphous silicon (a-Si), but is not limited thereto.

Each of the transistors DT and ST in each of the subpixels SP1, SP2, SP3, and SP4 includes a gate electrode, a source electrode, and a drain electrode. Since the source electrode and the drain electrode are not fixed and can be changed according to a voltage and a current direction applied to the gate electrode, one of the source electrode and the drain electrode can be referred to as a first electrode, and the other can be represented as a second electrode. The transistors DT and ST of each of the subpixels SP1, SP2, SP3, and SP4 can use at least one of polysilicon semiconductor, amorphous silicon semiconductor, and oxide semiconductor. The transistors DT and ST can be P-type or N-type transistors, or P-type and N-type transistors can be used interchangeably.

The light emitting device ED can include an anode electrode connected to the driving transistor DT, a cathode electrode supplied with a second power voltage EVSS from the second power line VSSL, and an emission layer between the anode electrode and the cathode electrode. The anode electrode can be an independent electrode for each light emitting device, however, the cathode electrode can be a common electrode shared by all light emitting devices. When a driving current is supplied from the driving transistor DT, electrons from the cathode electrode are injected into the emission layer, and holes from the anode electrode are injected into the emission layer, whereby fluorescent or phosphorescent materials are emitted from the emission layer by recombination of the electrons and holes, thereby generating light having brightness proportional to a current value of the driving current.

In each of the subpixels SP1, SP2, SP3, and SP4, the driving transistor DT is connected between the anode electrode of the light emitting device ED and the first power line VDDL for supplying the driving voltage EVDD. Herein, the driving voltage EVDD is applied to the first electrode of the driving transistor DT.

The driving transistor DT is a transistor for driving the light emitting device ED and is controlled according to a voltage applied to the gate electrode, to thereby supply the current to the light emitting device ED. Accordingly, the light emitting device ED is driven.

In each of the subpixels SP1, SP2, SP3, and SP4, the switching transistor ST is connected between a first node N1 of the driving transistor DT and the data line DL. The switching transistor ST is controlled by the scan signal Scan from the scan line SCANL and is configured to apply the data voltage Vdata supplied from the data line DL to the first node N1.

In each of the subpixels SP1, SP2, SP3, and SP4, the capacitor Cst is connected to the first node N1 and is charged with the voltage applied to the first node N1. The capacitor Cst can supply the charged driving voltage to the driving transistor DT. The capacitor Cst is a storage capacitor.

The compensation circuit CC can be provided to compensate for a threshold voltage of the driving transistor DT. The compensation circuit CC can include one or more transistors. The compensation circuit CC can include one or more transistors and capacitors and can be variously configured according to a compensation method. The pixel including the compensation circuit CC can have various structures such as 3T1C, 4T2C, 5T2C, 6T1C, 6T2C, 7T1C, 7T2C, and the like.

Hereinafter, the circuit device, the light emitting device ED, and an anode connection line ACL provided in the transparent display panel 110 according to an example embodiment of the present disclosure will be described in more detail with reference to FIGS. 4 to 9.

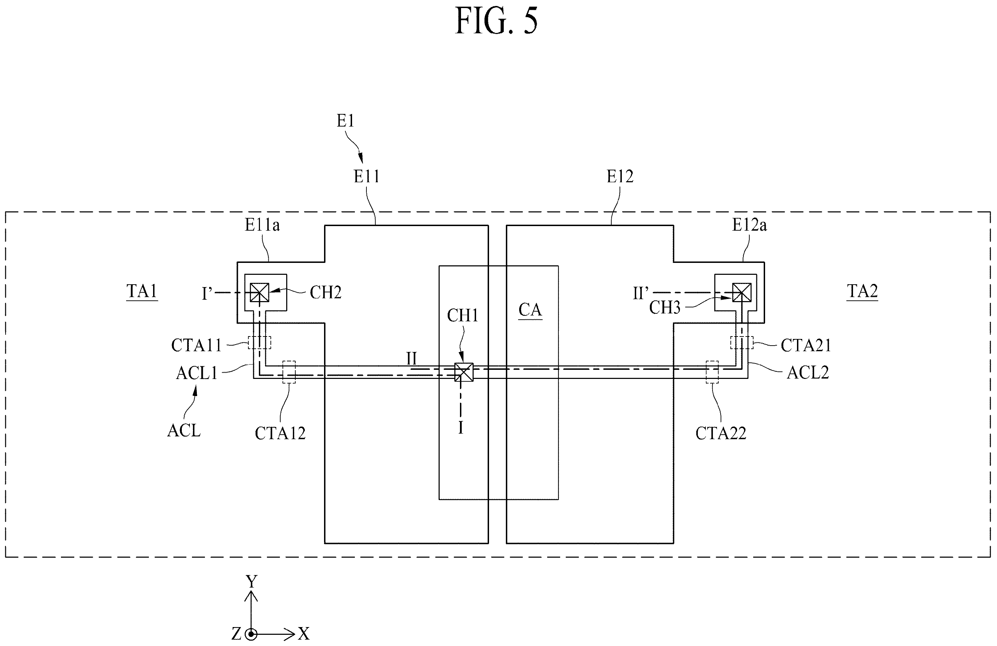

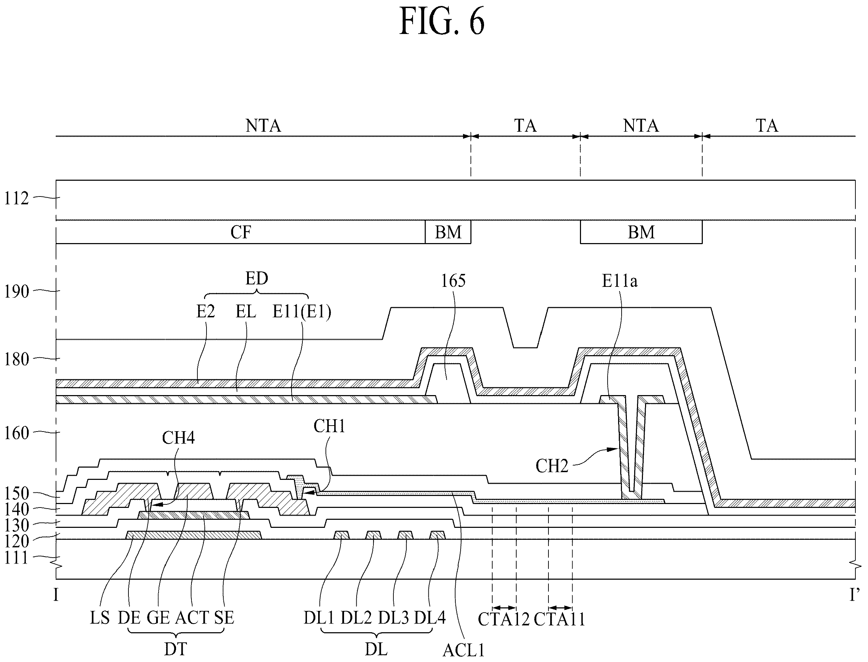

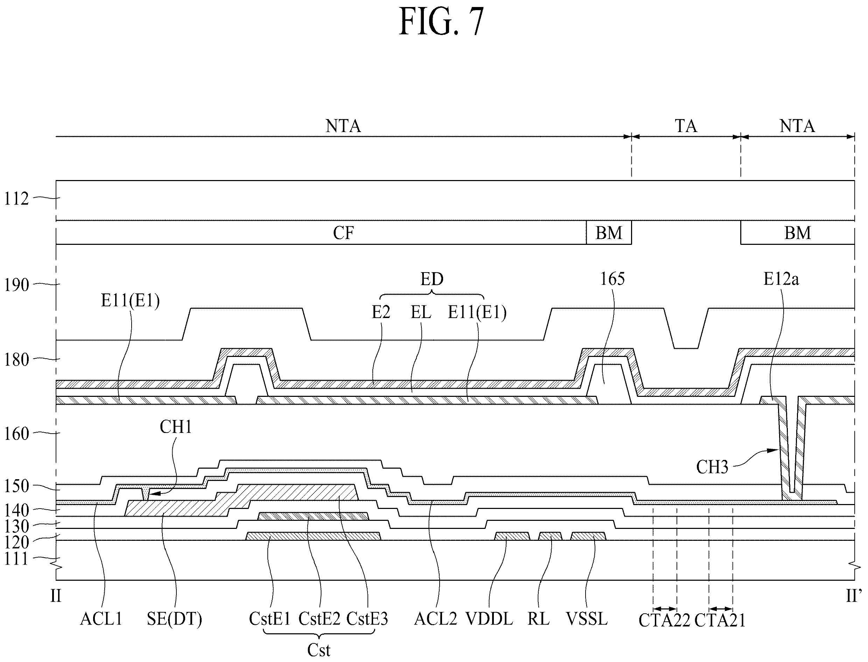

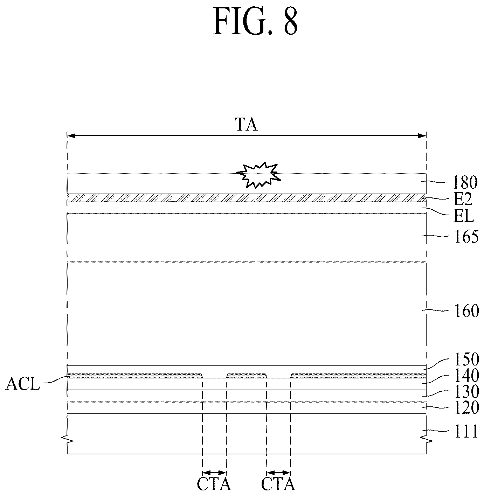

FIG. 5 is an enlarged view illustrating an example of an anode connection line, FIG. 6 is a cross-sectional view illustrating an example along I-I' of FIG. 5, and FIG. 7 is a cross-sectional view illustrating an example along II-II' of FIG. 5. FIG. 8 illustrates an example in which a cathode electrode and an encapsulation layer are damaged by a laser-cutting process.

Referring to FIGS. 4 to 8, the transparent display panel 110 according to an example embodiment of the present disclosure includes a first substrate 111 and a second substrate 112 confronting each other. Also, the circuit device, the anode connection line ACL, the light emitting device ED, an encapsulation layer 180, a color filter CF, and a black matrix BM can be disposed between the first substrate 111 and the second substrate 112.

The circuit device can be disposed in each of the subpixels SP1, SP2, SP3, and SP4 in the non-transmissive area NTA, and can include various signal lines, thin film transistors, and capacitor. The signal lines can include scan lines, data lines, power lines, and the like, and the thin film transistors can include a switching transistor and a driving transistor DT. The switching transistor can be switched according to a scan signal supplied to the scan line and can be configured to charge a data voltage supplied from the data line to the capacitor Cst.

The driving transistor DT and the capacitor Cst can be disposed in the non-transmissive area NTA and can be connected to the light emitting device ED of each of the plurality of subpixels SP1, SP2, SP3, and SP4.

The driving transistor DT includes an active layer ACT, a gate electrode GE, a source electrode SE, and a drain electrode DE. The capacitor Cst can include a first capacitor electrode CstE1, a second capacitor electrode CstE2, and a third capacitor electrode CstE3, but not limited thereto. In another example embodiment, the capacitor Cst can be formed of two capacitor electrodes.

Specifically, a light shielding layer LS can be provided on the first substrate 111. The light shielding layer LS may block external light and may prevent the characteristics of components disposed inside the display panel from changing due to external light. Additionally, the light shielding layer LS may include a metal material, and may transmit an electrical signal. The light shielding layer LS can be provided to overlap the area where the driving transistor DT is formed, and can serve to block external light incident on the active layer ACT of the driving transistor DT. The first capacitor electrode CstE1 of the capacitor Cst can be provided on the same layer as the light shielding layer LS.

The light shielding layer LS and the first capacitor electrode CstE1 of the capacitor Cst can be formed in a single layer or multiple layers from any one of molybdenum Mo, aluminum Al, chromium Cr, gold Au, titanium Ti, nickel Ni, neodymium Nd, and copper Cu, or an alloy thereof.

A buffer layer 120 can be provided on the light shielding layer LS. The buffer layer 120 can protect the driving transistor DT from impurities such as hydrogen and moisture penetrating through the first substrate 111 vulnerable to moisture permeation, and can extend not only to the display area DA including the non-transmissive area NTA and the transmissive area TA but also to the non-display area NDA including the pad area PA. The buffer layer 120 can have a single-layered structure or multi-layered structure including an inorganic insulating material such as silicon oxide SiOx, silicon nitride SiNx, and aluminum oxide Al₂O₃. For example, the buffer layer 120 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto. However, the buffer layer 120 may be excluded in accordance with the structure or properties of the display device.

The active layer ACT of the driving transistor DT can be provided on the buffer layer 120. In addition, the second capacitor electrode CstE2 of the capacitor Cst can be provided on the same layer as the active layer ACT of the driving transistor DT. In this case, the second capacitor electrode CstE2 of the capacitor Cst can be spaced apart from the active layer ACT of the driving transistor DT. The second capacitor electrode CstE2 of the capacitor Cst and the active layer ACT of the driving transistor DT can be formed of a silicon-based semiconductor material or an oxide-based semiconductor material.

A gate insulating layer 130 can be provided on the second capacitor electrode CstE2 of the capacitor Cst and the active layer ACT of the driving transistor DT. The gate insulating layer 130 can be formed of an inorganic layer, for example, a silicon oxide layer SiOx, a silicon nitride layer SiNx, or a multilayer thereof. For example, the gate insulating layer 130 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

The gate electrode GE, the source electrode SE, and the drain electrode DE of the driving transistor DT can be provided on the gate insulating layer 130. The gate electrode GE, the source electrode SE, and the drain electrode DE of the driving transistor DT can be formed of the same material on the same layer as shown in FIG. 6, but not limited thereto. In another example embodiment, the source electrode SE and the drain electrode DE of the driving transistor DT can be formed of the different material from that of the gate electrode GE and can be disposed on the different layer from that of the gate electrode GE. The source electrode SE and the drain electrode DE can be connected to the active layer ACT through a fourth contact hole CH4 passing through the gate insulating layer 130.

In addition, the third capacitor electrode CstE3 of the capacitor Cst can be provided on the same layer as the gate electrode GE, the source electrode SE, and the drain electrode DE of the driving transistor DT. The third capacitor electrode CstE3 of the capacitor Cst can extend from one of the source electrode SE and the drain electrode DE of the driving transistor DT. Accordingly, the third capacitor electrode CstE3 of the capacitor Cst can be electrically connected to one of the source electrode SE and the drain electrode DE of the driving transistor DT.

The third capacitor electrode CstE3 of the capacitor Cst and the gate electrode GE, the source electrode SE, and the drain electrode DE of the driving transistor DT can be formed in a single layer or multiple layers from any one of molybdenum Mo, aluminum Al, chromium Cr, gold Au, titanium Ti, nickel Ni, neodymium Nd, and copper Cu, or an alloy thereof.

A first insulating layer 140 can be provided on the third capacitor electrode CstE3 of the capacitor Cst and the gate electrode GE, the source electrode SE, and the drain electrode DE of the driving transistor DT. The first insulating layer 140 can be formed of an inorganic layer, for example, a silicon oxide SiOx layer, a silicon nitride SiNx layer, or a multilayer thereof. For example, the first insulating layer 140 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

The anode connection line ACL can be provided on the first insulating layer 140. The anode connection line ACL can electrically connect the driving transistor DT to the first electrode E1 of the light emitting device ED. A detailed description of the anode connection line ACL will be described later.

A second insulating layer 150 for protecting the driving transistor DT, the capacitor Cst, and the anode connection line ACL can be provided on the anode connection line ACL. The second insulating layer 150 can be formed of an inorganic layer, for example, a silicon oxide SiOx layer, a silicon nitride SiNx layer, or a multilayer thereof. For example, the second insulating layer 150 may be formed by inorganic film in a single layer or in multiple layers, for example, the inorganic film in a single layer may be a silicon oxide (SiOx) film or a silicon nitride (SiNx) film, and inorganic films in multiple layers may formed by alternately stacking one or more silicon oxide (SiOx) films, one or more silicon nitride (SiNx) films, and one or more amorphous silicon (a-Si), but the present disclosure is not limited thereto.

A planarization layer 160 for planarizing a step difference formed by the driving transistor DT, the capacitor Cst, and the anode connection line ACL can be provided on the second insulating layer 150. The planarization layer 160 can be formed of an organic layer such as acryl resin, epoxy resin, phenolic resin, polyamide resin, polyimide resin, or the like.

At least one of the first insulating layer 140, the second insulating layer 150, and the planarization layer 160 can be provided in the non-transmissive area NTA and cannot be provided in at least a portion of the transmissive area TA. At least one of the first insulating layer 140, the second insulating layer 150, and the planarization layer 160 can include an opening region overlapping at least a portion of the transmissive area TA. At least one of the first insulating layer 140, the second insulating layer 150, and the planarization layer 160 can cause light refraction and the like while light is transmitted, thereby deteriorating transparency. Accordingly, the transparent display panel 110 according to another example embodiment of the present disclosure can increase transparency by removing a portion of at least one of the first insulating layer 140, the second insulating layer 150, and the planarization layer 160 in the transmissive area TA.

The light emitting devices ED including the first electrode E1, the emission layer EL, and the second electrode E2 and a bank 165 are provided on the planarization layer 160.

The first electrode E1 can be provided on the planarization layer 160 and can be electrically connected to the driving transistor DT. The first electrode E1 can be electrically connected to one of the source electrode SE and the drain electrode DE of the driving transistor DT through the anode connection line ACL.

In detail, the plurality of first electrodes E1 can be provided in each of the plurality of subpixels SP1, SP2, SP3, and SP4. For example, the first electrode E1 can include a first anode electrode E11 and a second anode electrode E12. The first anode electrode E11 can be disposed in the first sub-emission area EA11, EA21, EA31, and EA41, and the second anode electrode E12 can be disposed in the second sub-emission area EA12, EA22, EA32, and EA42. The first anode electrode E11 and the second anode electrode E12 can be spaced apart from each other in the same layer.

The first anode electrode E11 and the second anode electrode E12 can be provided between the transmissive areas TA disposed adjacent to each other in the first direction (eg, X-axis direction). In detail, as shown in FIG. 5, the transmissive area TA can include a first transmissive area TA1 and a second transmissive area TA2 spaced apart from each other in the first direction (eg, X-axis direction). The first anode electrode E11 and the second anode electrode E12 can be disposed between the first transmissive area TA1 and the second transmissive area TA2. In this case, the first anode electrode E11 and the second anode electrode E12 can be disposed adjacent to each other in the first direction (eg, X-axis direction) between the first transmissive area TA1 and the second transmissive area TA2. The first anode electrode E11 and the second anode electrode E12 can be disposed adjacent to each other in the first direction (eg, X-axis direction), which is an extension direction of the second signal line SL2, however, the present disclosure is not limited thereto.

One side of the first anode electrode E11 can be disposed adjacent to the first transmissive area TA1. The first anode electrode E11 can include a first protrusion E11a protruding from one side toward the first transmissive area TA1 in order to be connected to the anode connection line ACL. One side of the second anode electrode E12 can be disposed adjacent to the second transmissive area TA2. The second anode electrode E12 can include a second protrusion E12a protruding from one side toward the second transmissive area TA2 in order to be connected to the anode connection line ACL. Since the first anode electrode E11 and the second anode electrode E12 are disposed adjacently in the first direction (eg, X-axis direction), the plurality of first signal lines SL1 can be disposed between the first protrusion E11a of the first anode electrode E11 and the second protrusion E12a of the second anode electrode E12. However, the present disclosure is not limited thereto. For example, the first anode electrode E11 and the second anode electrode E12 may be disposed adjacently in a second direction (eg, Y-axis direction), and a plurality of signal lines may extend along the second direction.

The first anode electrode E11 and the second anode electrode E12 can be electrically connected to the driving transistor DT through the anode connection line ACL. The first anode electrode E11 and the second anode electrode E12 can be electrically connected to the same driving transistor DT and can be supplied with the same driving current from the driving transistor DT.

The anode connection line ACL can be electrically connected to one of the source electrode SE and the drain electrode DE of the driving transistor DT through a first contact hole CH1 in the non-transmissive area NTA. The anode connection line ACL can extend in the first direction (eg, X-axis direction) in the non-transmissive area NTA, whereby one end of the anode connection line ACL can be connected to the first anode electrode E11 and the other end thereof can be connected to the second anode electrode E12. The anode connection line ACL extends from the first transmissive area TA1 to the second transmissive area TA2 across the non-transmissive area NTA.

In detail, the anode connection line ACL can include a first anode connection line ACL1 and a second anode connection line ACL2 The first anode connection line ACL1 can extend from the first contact hole CH1 toward the first transmissive area TA1, whereby one end of the first anode connection line ACL1 can be connected to the first anode electrode E11. The first anode connection line ACL1 can at least partially overlap the first anode electrode E11 between the first transmissive area TA1 and the circuit area CA including the driving transistor DT. At least a portion of one end of the first anode connection line ACL1 can overlap the first protrusion E11a of the first anode electrode E11 between the first transmissive area TA1 and the circuit area CA including the driving transistor DT and can be electrically connected to the first protrusion E11a of the first anode electrode E11 through a second contact hole CH2. Accordingly, the first anode connection line ACL1 can electrically connect the first anode electrode E11 to the driving transistor DT.

The second anode connection line ACL2 can extend from the first contact hole CH1 toward the second transmissive area TA2, whereby one end of the second anode connection line ACL2 can be connected to the second anode electrode E12. The second anode connection line ACL2 can at least partially overlap the second anode electrode E12 between the second transmissive area TA2 and the circuit area CA including the driving transistor DT. At least a portion of one end of the second anode connection line ACL2 can overlap the second protrusion E12a of the second anode electrode E12 between the second transmissive area TA2 and the circuit area CA including the driving transistor DT and can be electrically connected to the second protrusion E12a of the second anode electrode E12 through the third contact hole CH3. Accordingly, the second anode connection line ACL2 can electrically connect the second anode electrode E12 to the driving transistor DT.

The first anode connection line ACL1 and the second anode connection line ACL2 can be connected to each other in the same layer. The first anode connection line ACL1 and the second anode connection line ACL2 can be connected to the driving transistor DT through one first contact hole CH1 and can be connected to the first anode electrode E11 and the second anode electrode E12 through the different contact holes CH2 and CH3, respectively. For example, the first anode connection line ACL1 can be connected to the driving transistor DT through first contact hole CH1 and can be connected to the first anode electrode E11 through second contact hole CH2, and the second anode connection line ACL2 can be connected to the driving transistor DT through first contact hole CH1 and can be connected to the second anode electrode E12 through third contact hole CH3. The driving transistor DT can be disposed between the second contact hole CH2 and the third contact hole CH3 in a plan view. The first anode connection line ACL1 and the second anode connection line ACL2 can be connected to the driving transistor DT through one first contact hole CH1 between the second contact hole CH2 and the third contact hole CH3 and can extend toward the transmissive areas TA1 and TA2, respectively. In an example embodiment, the first anode connection line ACL1 and the second anode connection line ACL2 can be formed in a straight line extending in the first direction (eg, X-axis direction) in the non-transmissive area NTA.

The first electrode E1 including the first anode electrode E11 and the second anode electrode E12 can be provided for each of the subpixels SP1, SP2, SP3, and SP4, and cannot be provided in the transmissive area TA. The bank 165 can be provided between the first electrodes E1 adjacent to each other, whereby the first electrodes E1 adjacent to each other can be electrically insulated from each other.

The first electrode E1 can be formed of a metal material having high reflectance, such as a stacked structure Ti/Al/Ti of aluminum and titanium, a stacked structure ITO/Al/ITO of aluminum and ITO, an Ag alloy, a stacked structure ITO/Ag alloy/ITO of Ag alloy and ITO, MoTi alloy, and a stacked structure ITO/MoTi alloy/ITO of MoTi alloy and ITO. The Ag alloy can be an alloy of silver Ag, palladium Pd, and copper Cu. The MoTi alloy can be an alloy of molybdenum Mo and titanium Ti. The first electrode E1 can be an anode electrode. Hereinafter, the first electrode E1 can be referred to as the anode electrode. The first electrode and the anode electrode can have the same configuration.

The bank 165 can be provided on the planarization layer 160. The bank 165 may be disposed at a boundary between the plurality of subpixels SP and suppress a color mixture of light beams from the plurality of subpixels SP. In addition, the bank 165 can be provided between the first electrodes E1 provided in each of the plurality of subpixels SP1, SP2, SP3, and SP4. The bank 165 can cover the edge of each of the first electrodes E1 and can be formed to expose a portion of each of the first electrodes E1. Accordingly, the bank 165 can prevent a current from being concentrated at an end of each of the first electrodes E1 so that it is possible to prevent or reduce a deterioration of light emitting efficiency.

The bank 165 can define the emission area EA1, EA2, EA3, and EA4 of each of the subpixels SP1, SP2, SP3, and SP4. The emission areas EA1, EA2, EA3, and EA4 of the subpixels SP1, SP2, SP3, and SP4, respectively, are areas in which the first electrode E1, the emission layer EL, and the second electrode E2 are sequentially stacked to allow holes from the first electrode E1 and electrons from the second electrode E2 to be bonded to each other in the emission layer EL to emit light. In this case, the area where the bank 165 is not formed and the first electrode E1 is exposed can be the emission area EA1, EA2, EA3, and EA4.

The bank 165 can be formed of an organic layer such as an acryl-based material, an epoxy-based material, a phenolic-based material, a polyamide-based material, or a polyimide-based material. Meanwhile, the bank 165 may include an inorganic insulating material, such as silicon nitride (SiNx) or silicon oxide (SiOx), or the bank 165 may be formed of black resin. However, the present disclosure is not limited thereto.

The emission layer EL can be disposed on the first electrode E1. The emission layer EL can include an emission material layer EML including a light emitting material. The light emitting material can include an organic material, an inorganic material, or a hybrid material. The emission layer EL can have a multi-layer structure. For example, the emission layer EL can further include at least one of a hole injection layer HIL , a hole transport layer HTL, an electron transport layer ETL, and an electron injection layer EIL. In this case, when a voltage is applied to the first electrode E1 and the second electrode E2, holes and electrons move to the emission material layer through the hole transport layer and the electron transport layer, respectively, and are combined with each other in the emission material layer to emit light.

In an example embodiment, the emission layer EL can be a common layer commonly formed in the subpixels SP1, SP2, SP3, and SP4. In this case, the emission layer EL can be a white emission layer which emits white light. The emission layer EL can be provided not only in the non-transmissive area NTA including the emission areas EA1, EA2, EA3, and EA4, but also in the transmissive area TA, but not limited thereto. The emission layer EL can be patterned only in the non-transmissive area NTA including the emission areas EA1, EA2, EA3, and EA4.

In another example embodiment, the emission layer EL can be formed for each of the subpixels SP1, SP2, SP3, and SP4. For example, a white emission layer for emitting white light can be formed in the first subpixel SP1, a green emission layer for emitting green light can be formed in the second subpixel SP2, a red emission layer for emitting red light can be formed in the third subpixel SP3, and a blue emission layer for emitting blue light can be formed in the fourth subpixel SP4. In this case, the emission material layer of the emission layer EL cannot be formed in the transmissive area TA. However, except for the emission material layer, the hole injection layer HIL, the hole transport layer HTL, the electron transport layer ETL, and the electron injection layer EIL can be commonly formed in the subpixels SP1, SP2, SP3, and SP4, and can also be formed in the transmissive area TA.

The second electrode E2 can be disposed on the emission layer EL. The second electrode E2 can be a common layer commonly formed in the subpixels SP1, SP2, SP3, and SP4 and configured to apply the same voltage.

The second electrode E2 can be formed of a transparent conductive material TCO capable of transmitting light therethrough such as indium tin oxide ITO and indium zinc oxide IZO, or a semi-transmissive conductive material such as magnesium Mg, silver Ag, or an alloy of magnesium Mg and silver Ag. When the second electrode E2 is formed of a semi-transmissive metal material, a light emission efficiency can be increased by a microcavity. The second electrode E2 can be a cathode electrode of the light emitting device ED. Hereinafter, the second electrode E2 can be referred to as the cathode electrode. The second electrode and the cathode electrode can have the same configuration.

The encapsulation layer 180 can be provided on the light emitting devices ED. The encapsulation layer 180 can be formed on the second electrode E2 and configured to cover the second electrode E2. The encapsulation layer 180 prevents oxygen or moisture from penetrating into the emission layer EL and the second electrode E2. To this end, the encapsulation layer 180 can include at least one inorganic layer and at least one organic layer. The encapsulation layer 180 can have a structure in which an inorganic layer and an organic layer are alternately stacked, but not limited thereto.

For example, the encapsulation layer 180 has a structure in which inorganic encapsulation layers and organic encapsulation layers are alternately stacked, such that the encapsulation layer 180 may protect the light-emitting element while inhibiting moisture or oxygen from penetrating into the light-emitting element. For example, the encapsulation layer 180 may have a multi-insulating film structure in which organic films and inorganic films are stacked alternately. The inorganic film can block permeation of moisture or oxygen. The organic film may planarize a surface of the inorganic film. When the organic film and the inorganic film are stacked in multiple layers, a movement path of moisture or oxygen may be longer than that of a single layer, thereby effectively blocking the permeation of moisture and oxygen affecting the light emitting layer. For example, the encapsulation layer 180 includes a first inorganic encapsulation layer, a first organic encapsulation layer, and a second inorganic encapsulation layer stacked sequentially. For example, the encapsulation layer 180 includes a first inorganic encapsulation layer, a first organic encapsulation layer, a second inorganic encapsulation layer, a second organic encapsulation layer, and a third inorganic encapsulation layer stacked sequentially. However, the present disclosure is not limited thereto.

The first inorganic encapsulation layer, the second inorganic encapsulation layer, and the third inorganic encapsulation layer may serve to block the penetration of moisture or oxygen. The first inorganic encapsulation layer, the second inorganic encapsulation layer, and the third inorganic encapsulation layer may be made of an inorganic material, for example, an inorganic material such as silicon nitride (SiNx), silicon oxide (SiOx), or aluminum oxide (AlOx). However, the present disclosure is not limited thereto.

The first organic encapsulation layer is disposed between the first inorganic encapsulation layer and the second inorganic encapsulation layer, and the second organic encapsulation layer is disposed between the second inorganic encapsulation layer and the third inorganic encapsulation layer. The first organic encapsulation layer and the second organic encapsulation layer may each have a larger thickness than each of the first inorganic encapsulation layer, the second inorganic encapsulation layer, and the third inorganic encapsulation layer in order to adsorb or block particles that may be produced during a process of manufacturing the display device. The first organic encapsulation layer and the second organic encapsulation layer may fill cracks that may be formed in the first inorganic encapsulation layer and the second inorganic encapsulation layer. The first organic encapsulation layer and the second organic encapsulation layer may planarize an upper portion of the first inorganic encapsulation layer and an upper portion of the second inorganic encapsulation layer by covering particles on the first inorganic encapsulation layer and the second inorganic encapsulation layer respectively. For example, the first organic encapsulation layer may planarize an upper portion of the first inorganic encapsulation layer by covering particles on the first inorganic encapsulation layer. For example, the second organic encapsulation layer may planarize an upper portion of the second inorganic encapsulation layer by covering particles on the second inorganic encapsulation layer. The first organic encapsulation layer and the second organic encapsulation layer may be made of an organic material, and for example, epoxy polymer, acrylic polymer, or the like may be used. However, the present disclosure is not limited thereto.

Meanwhile, the encapsulation layer 180 is not limited to three or five layers, for example, n layers alternately stacked between inorganic encapsulation layer and organic encapsulation layer (where n is an integer greater than 3) may be included.

Meanwhile, a capping layer can be additionally formed between the second electrode E2 and the encapsulation layer 180.

The color filter CF can be provided on the encapsulation layer 180. The color filter CF can be provided on one surface of the second substrate 112 confronting the first substrate 111. The color filter CF can be patterned for each of the subpixels SP1, SP2, SP3, and SP4.

Specifically, the color filter CF can include a first color filter, a second color filter, a third color filter, and a fourth color filter. The first color filter can be disposed to correspond to the emission area EA1 of the first subpixel SP1 and can be a red color filter which transmits red light. The second color filter can be disposed to correspond to the emission area EA2 of the second subpixel SP2 and can be a green color filter which transmits green light. The third color filter can be disposed to correspond to the emission area EA3 of the third subpixel SP3 and can be a blue color filter which transmits blue light. The fourth color filter can be disposed to correspond to the emission area EA4 of the fourth subpixel SP4 and can be a white color filter which transmits white light. The white color filter can be formed of a transparent organic material which transmits white light.

The black matrix BM can be provided between the color filters CF patterned in the respective subpixels SP1, SP2, SP3, and SP4. The black matrix BM can be provided between the subpixels SP1, SP2, SP3, and SP4 and can be configured to prevent or reduce color mixing between the subpixels SP1, SP2, SP3, and SP4. In addition, the black matrix BM can prevent or reduce light incident from the outside from being reflected to the plurality of signal lines provided between the subpixels SP1, SP2, SP3, and SP4.

Also, the black matrix BM can be provided between the transmissive area TA and the plurality of subpixels SP1, SP2, SP3, and SP4 and can prevent light emitted from each of the plurality of subpixels SP1, SP2, SP3, and SP4 from proceeding to the transmissive area TA. The black matrix BM can include a light-absorbing material, for example, a black dye which absorbs all light in a visible light wavelength range.

The aforementioned color filter CF and black matrix BM are not provided in the transmissive area TA in order to maintain a high light transmittance in the transmissive area TA.

The first substrate 111 including the light emitting devices ED and the second substrate 112 including the color filter CF and the black matrix BM can be bonded to each other by a filler 190. The filler 190 can be formed of thermosetting resin or UV curable resin and can be formed of an organic material having an adhesive property. In an example embodiment, the filler 190 can include a material which absorbs hydrogen.

The transparent display panel 110 according to an example embodiment of the present disclosure can connect the anode electrode E1 and the driving transistor DT by using the anode connection line ACL. In detail, one end of the anode connection line ACL can be electrically connected to the first anode electrode E11 through the second contact hole CH2 and the other end of the anode connection line ACL can be electrically connected to the second anode electrode E12 through the third contact hole CH3.

In this case, the first anode electrode E11 and the second anode electrode E12 can be disposed to be adjacent in the first direction (eg, X-axis direction) between the transmissive areas TA disposed adjacent to each other in the first direction (eg, X-axis direction). That is, the first anode electrode E11 and the second anode electrode E12 can be disposed adjacent to each other in the first direction (eg, X-axis direction), which is the extension direction of the scan line SCANL.

In the transparent display panel 110 according to an example embodiment of the present disclosure, only one subpixel SP1, SP2, SP3, or SP4 can be disposed within a separation width of the transmissive areas TA disposed adjacently in the first direction (eg, X-axis direction). In the transparent display panel 110 according to an example embodiment of the present disclosure, a width in the first direction (eg, X-axis direction) of the subpixels SP1, SP2, SP3, and SP4 can increase, whereby a viewing angle can increase.

Also, in the transparent display panel 110 according to an example embodiment of the present disclosure, only one subpixel SP1, SP2, SP3, or SP4 is disposed within a separation width of the transmissive areas TA disposed adjacently in the first direction (eg, X-axis direction), whereby it is possible to reduce a width in the first direction (eg, X-axis direction) of the non-transmissive area NTA. Accordingly, the transparent display panel 110 according to an example embodiment of the present disclosure can increase the area of the transmissive area TA and improve the light transmittance.

According to the arrangement direction of the first anode electrode E11 and the second anode electrode E12, the anode connection line ACL can extend in the first direction (eg, X-axis direction) between the transmissive areas TA disposed adjacently to the first direction (eg, X-axis direction). The first anode electrode E11 can include a first protrusion E11a protruding from one side toward the first transmissive area TA1 to contact the anode connection line ACL. The anode connection line ACL can be connected to the first protrusion E11a of the first anode electrode E11 protruding to the first transmissive area TA1 through the second contact hole CH2. Meanwhile, the second anode electrode E12 can include a second protrusion E12a protruding from one side toward the second transmissive area TA2 to contact the anode connection line ACL. The anode connection line ACL can be connected to the second protrusion E12a of the second anode electrode E12 protruding to the second transmissive area TA2 through the third contact hole CH3.

As described above, the second contact hole CH2 configured to connect the first anode electrode E11 and the anode connection line ACL can be disposed adjacent to the first transmissive area TA1, and the third contact hole CH3 configured to connect the second anode electrode E12 and the anode connection line ACL can be disposed adjacent to the second transmissive area TA2. For example, the second contact hole CH2 and the third contact hole CH3 can be spaced apart from each other with the plurality of first signal lines SL1 provided therebetween in the non-transmissive area NTA.

As a separation distance between the second contact hole CH2 and the third contact hole CH3 is large, a separation distance between a cutting area for repairing the first anode electrode E11 and a cutting area for repairing the second anode electrode E12 can be large.

Specifically, when a defect occurs in at least one of the plurality of subpixels SP1, SP2, SP3, and SP4, the transparent display panel 110 according to an example embodiment of the present disclosure can repair by cutting at least a portion of the anode connection line ACL. In the transparent display panel 110 according to an example embodiment of the present disclosure, foreign substances or the like can be introduced into any one of the first anode electrode E11 and the second anode electrode E12 for a manufacturing process, whereby a dark spot can occur. In this case, the transparent display panel 110 according to an example embodiment of the present disclosure can repair the anode connection line ACL by cutting at least a portion of the anode connection line ACL.

The anode connection line ACL can be divided into the first anode connection line ACL1 for connecting the first anode electrode E11 and the driving transistor DT and the second anode connection line ACL2 for connecting the second anode electrode E12 and the driving transistor DT. The first anode connection line ACL1 can be provided with a first cutting area CTA11 and CTA12 in a region being not overlapped with the first anode electrode E11, and the second anode connection line ACL2 can be provided with a second cutting area CTA21 and CTA22 in a region being not overlapped with the second anode electrode E12.

In the transparent display panel 110 according to an example embodiment of the present disclosure, among areas in which the first anode electrode E11 and the second anode electrode E12 are formed, a defect can occur in the area in which the first anode electrode E11 is formed. During the process, foreign substances can be introduced onto the first anode electrode E11, whereby a short circuit can occur between the first anode electrode E11 and the second electrode E2. In this case, the first anode connection line ACL1 can be cut in such a way the first cutting area CTA11 and CTA12 is cut by laser. Accordingly, the first anode electrode E11 can be electrically separated from the driving transistor DT and the second anode electrode E12. Even if the area where the first anode electrode E11 is provided is darkened, the area where the second anode electrode E12 is provided can normally operate and emit light.

Meanwhile, in the transparent display panel 110 according to an example embodiment of the present disclosure, among the areas in which the first anode electrode E11 and the second anode electrode E12 are formed, a defect can occur in the area in which the second anode electrode E12 is formed. During the process, foreign substances can be introduced onto the second anode electrode E12, whereby a short circuit can occur between the second anode electrode E12 and the second electrode E2. In this case, the second anode connection line ACL2 can be cut in such a way the second cutting area CTA21 and CTA22 is cut by laser. Accordingly, the second anode electrode E12 can be electrically separated from the driving transistor DT and the first anode electrode E11. Even if the area where the second anode electrode E12 is provided is darkened, the area where the first anode electrode E11 is provided can normally operate and emit light.

In the transparent display panel 110 according to an example embodiment of the present disclosure, even if a defect occurs due to foreign substances, only the corresponding anode electrode among the plurality of divided anode electrodes E11 and E12 can be short-circuited through the laser cutting, thereby reducing a light loss rate due to occurrence of defect.

In the transparent display panel 110 according to an example embodiment of the present disclosure, a defect can occur in the circuit device, for example, the driving transistor DT. In this case, the first anode connection line ACL1 can be cut by cutting the first cutting area CAT11 and CTA12 through the use of laser, and the second anode connection line ACL2 can be cut by cutting the second cutting area CTA21 and CTA22 through the use of laser. Accordingly, the driving transistor DT can be electrically separated from the first anode electrode E11 and the second anode electrode E12.

Meanwhile, the first cutting area CTA11 and CTA12 and the second cutting area CTA21 and CTA22 can be disposed in the different transmissive areas TA1 and TA2. The first cutting area CTA11 and CTA12 of the first anode connection line ACL1 can be disposed in the first transmissive area TA1 or adjacent to the first transmissive area TA1, in the same manner as the second contact hole CH2. The second cutting area CTA21 and CTA22 of the second anode connection line ACL2 can be disposed in the second transmissive area TA2 or adjacent to the second transmissive area TA2, in the same manner as the third contact hole CH3. For example, the first cutting area CTA11 and CTA12 of the first anode connection line ACL1 and the second cutting area CTA21 and CTA22 of the second anode connection line ACL2 can be spaced apart from each other with the plurality of first signal lines SL1 provided therebetween and disposed in the non-transmissive area NTA, and a separation distance between the first cutting area CTA11 and CTA12 and the second cutting area CTA21 and CTA22 can be large.

The transparent display panel 110 according to an example embodiment of the present disclosure can greatly reduce a cutting failure rate during laser cutting by forming the large separation distance between the first cutting area CTA11 and CTA12 of the first anode connection line ACL1 and the second cutting area CTA21 and CTA22 of the second anode connection line ACL2.

In order to increase a cutting success rate for the anode connection line ACL, a high level of energy should be used during the laser irradiation. When the separation distance between the first cutting area CTA11 and CTA12 of the first anode connection line ACL1 and the second cutting area CTA21 and CTA22 of the second anode connection line ACL2 is small and the energy level of laser is high, damages such as cracks can occur in the cathode electrode E2 and the encapsulation layer 180 due to the laser irradiation with respect to the first cutting area CTA11 and CTA12 and the second cutting area CTA21 and CTA22 disposed adjacent to each other, as shown in FIG. 8, whereby deterioration can occur in the light emitting device ED.

In order to prevent or mitigate this problem, if the energy level of laser is lowered, the first cutting area CTA11 and CTA12 of the first anode connection line ACL1 and the second cutting area CTA21 and CTA22 of the second anode connection line ACL2 cannot be completely cut in the cutting process using laser.

In the transparent display panel 110 according to an example embodiment of the present disclosure, the first cutting area CTA11 and CTA12 of the first anode connection line ACL1 and the second cutting area CTA21 and CTA22 of the second anode connection line ACL2 are disposed in the dependent positions. Thus, even if laser is irradiated at a high energy level to each of the first cutting area CTA11 and CTA12 and the second cutting area CTA21 and CTA22, the cathode electrode E2 and the encapsulation layer 180 cannot be damaged. In addition, the transparent display panel 110 according to an example embodiment of the present disclosure can increase the cutting success rate by irradiating laser at a sufficient energy level to each of the first cutting area CTA11 and CTA12 and the second cutting area CTA21 and CTA22.

Meanwhile, in the transparent display panel 110 according to an example embodiment of the present disclosure, the first and second anode connection lines ACL1 and ACL2 can be formed in the layer provided between the driving transistor DT and the anode electrode E1. The first and second anode connection lines ACL1 and ACL2 can be provided on the different layer from the gate electrode GE, the source electrode SE, and the drain electrode DE of the driving transistor DT. The first and second anode connection lines ACL1 and ACL2 can be disposed on the gate electrode GE, the source electrode SE, and the drain electrode DE of the driving transistor DT. In addition, the first and second anode connection lines ACL1 and ACL2 can be provided on the different layer from the anode electrode E1. The first and second anode connection lines ACL1 and ACL2 can be disposed under the anode electrode E1.

The first and second anode connection lines ACL1 and ACL2 can be provided between the plurality of insulating layers provided between the driving transistor DT and the anode electrode E1. For example, the first and second anode connection lines ACL1 and ACL2 can be disposed between the first insulating layer 140 and the second insulating layer 150.

The first and second anode connection lines ACL1 and ACL2 can be formed of a material different from that of the gate electrode GE, the source electrode SE, and the drain electrode DE of the driving transistor DT. In addition, the first and second anode connection lines ACL1 and ACL2 can be formed of a material different from that of the anode electrode E1. However, the present disclosure is not limited thereto, the first and second anode connection lines ACL1 and ACL2 can be formed of a same material as that of the gate electrode GE, the source electrode SE, and the drain electrode DE of the driving transistor DT. Alternatively, the first and second anode connection lines ACL1 and ACL2 can be formed of a same material as that of the anode electrode E1.

The first and second anode connection lines ACL1 and ACL2 can be formed of a material whose oxidation degree is lower than that of the gate electrode GE, the source electrode SE, and the drain electrode DE of the driving transistor DT. For example, the first and second anode connection lines ACL1 and ACL2 can be formed of an alloy MoTi of molybdenum Mo and titanium Ti, or a stacked structure ITO/MoTi alloy/ITO of MoTi alloy and ITO, but not limited thereto.

The first and second anode connection lines ACL1 and ACL2 can be formed to be thinner than the gate electrode GE, the source electrode SE, and the drain electrode DE of the driving transistor DT. Each of the gate electrode GE, the source electrode SE, and the drain electrode DE of the driving transistor DT should have a minimum thickness or more required for operating reliability of the driving transistor DT. For example, each of the gate electrode GE, the source electrode SE, and the drain electrode DE of the driving transistor DT can have a thickness of about 6000Å. Each of the first and second anode connection lines ACL1 and ACL2 can be formed to have a thickness less than 6000Å. However, the present disclosure is not limited thereto.

When the first and second anode connection lines ACL1 and ACL2 are formed of the same material on the same layer as the gate electrode GE, the source electrode SE, or the drain electrode DE of the driving transistor DT, the first and second anode connection lines ACL1 and ACL2 can be formed to have the same thickness as the gate electrode GE, the source electrode SE, or the drain electrode DE of the driving transistor DT.

In this case, since the first and second anode connection lines ACL1 and ACL2 have a large thickness, the first and second anode connection lines ACL1 and ACL2 cannot be completely cut in the process of cutting at least one of the first cutting area CTA11 and CTA12 and the second cutting area CTA21 and CTA22 by using laser. That is, the first and second anode connection lines ACL1 and ACL2 provided on the same layer as the gate electrode GE, the source electrode SE, or the drain electrode DE of the driving transistor DT have a low cutting success rate in the laser cutting process, thereby increasing a product defect rate.

In the transparent display panel 110 according to an example embodiment of the present disclosure, the first and second anode connection lines ACL1 and ACL2 can be provided on the different layer from that of the gate electrode GE, the source electrode SE, or the drain electrode DE of the driving transistor DT. In this case, in the transparent display panel 110 according to an example embodiment of the present disclosure, the first and second anode connection lines ACL1 and ACL2 can be formed to be thinner than the gate electrode GE, the source electrode SE, or the drain electrode DE of the driving transistor DT, thereby increasing the cutting success rate in the laser cutting process. For example, the first and second anode connection lines ACL1 and ACL2 can be formed to have a thickness of 300Å. However, the present disclosure is not limited thereto.

Since the first and second anode connection lines ACL1 and ACL2 have a small thickness, it is possible to secure the complete cutting in the process of cutting at least one of the first cutting area CTA11 and CTA12 and the second cutting area CTA21 and CTA22 by using laser. That is, the first and second anode connection lines ACL1 and ACL2 can have a high cutting success rate, whereby a product defect rate can decrease. The transparent display panel 110 according to an example embodiment of the present disclosure can reduce manufacturing process costs, shorten manufacturing process time, and reduce production energy. In addition, the transparent display panel 110 according to the present disclosure can reduce the generation of greenhouse gas which can occur due to the manufacturing process, thereby implementing ESG (Environment/Social/Governance).

In addition, the first and second anode connection lines ACL1 and ACL2 can be cut well even if a low-level energy is used during the laser irradiation. In the laser cutting process, components around the cutting area cannot be damaged.

Since the first and second anode connection lines ACL1 and ACL2 are well cut with a low-level energy, the separation distance between the cutting area and the anode electrode E1 can be a minimum distance. Accordingly, the first and second anode connection lines ACL1 and ACL2 can protrude in the direction of the transmissive area TA, and a portion of the transmissive area TA reduced by the first and second anode connection lines ACL1 and ACL2 can be minimized. Furthermore, it is possible to minimize the reduction of light transmittance by the first and second anode connection lines ACL1 and ACL2.

Also, each of the first anode connection line ACL1 and the second anode connection line ACL2 can include one or more cutting areas. For example, as shown in FIG. 5, the first anode connection line ACL1 can include two of the first cutting areas CTA11 and CTA12 in the region being not overlapped with the first anode electrode E11. The second anode connection line ACL2 can include two of the second cutting areas CTA21 and CTA22 in the region being not overlapped with the second anode electrode E12. Each of the first anode connection line ACL1 and the second anode connection line ACL2 can form the plurality of cutting areas in the limited region. For example, each of the first anode connection line ACL1 and the second anode connection line ACL2 can include more than two cutting areas. Thus, even if the separation distance between the plurality of cutting areas decreases, the cathode electrode E2 and the encapsulation layer 180 cannot be damaged. In the transparent display panel 110 according to an example embodiment of the present disclosure, even if the laser cutting fails in one cutting area, the laser cutting can be re-performed in another cutting area. The transparent display panel 110 according to an example embodiment of the present disclosure can attempt the cutting process many times without any damages on the cathode electrode E2 and the encapsulation layer 180 so that it is possible to greatly increase the cutting success rate.

Also, in the transparent display panel 110 according to an example embodiment of the present disclosure, the first contact hole CH1 for connecting the anode connection line ACL and the driving transistor DT can be disposed between the active layer ACT of the driving transistor DT and the second capacitor electrode CstE2 of the capacitor Cst on the plane. That is, the first contact hole CH1 cannot overlap the active layer ACT of the driving transistor DT and the second capacitor electrode CstE2 of the capacitor Cst.

When the first contact hole CH1 passing through the first insulating layer 140 overlaps the active layer ACT of the driving transistor DT or the second capacitor electrode CstE2 of the capacitor Cst, the active layer ACT of the driving transistor DT or the second capacitor electrode CstE2 of the capacitor Cst can be exposed by the first contact hole CH1. Accordingly, the active layer ACT of the driving transistor DT or the second capacitor electrode CstE2 of the capacitor Cst can be in contact with the anode connection line ACL through the first contact hole CH1.

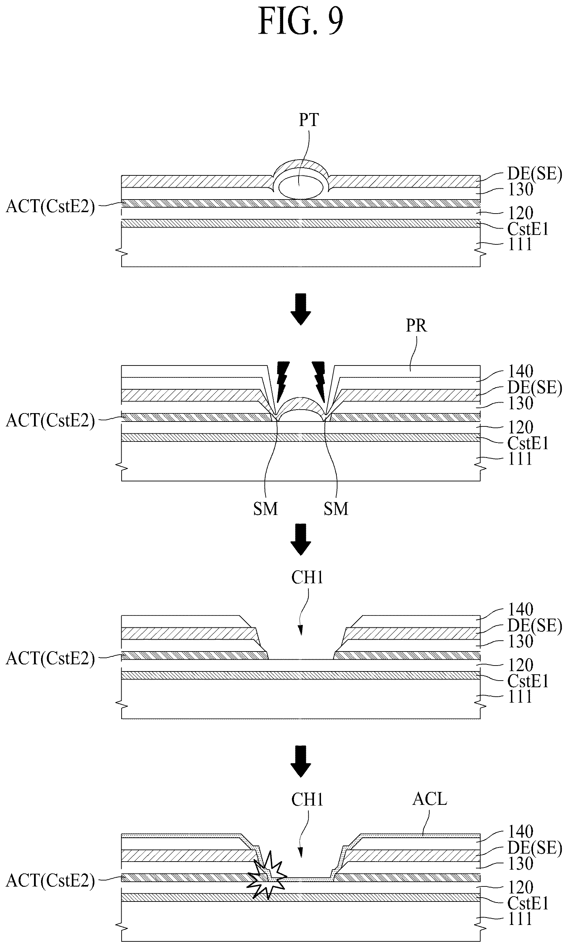

For example, as shown in FIG. 9, the first contact hole CH1 can overlap the second capacitor electrode CstE2 of the capacitor Cst provided on the same layer as that of the active layer ACT of the driving transistor DT.

As shown in FIG. 9, the gate insulating layer 130 and the drain electrode DE (or source electrode SE) can be sequentially stacked on the second capacitor electrode CstE2 of the capacitor Cst. In some cases, foreign substances PT generated during the manufacturing process can be introduced onto the second capacitor electrode CstE2 of the capacitor Cst before the gate insulating layer 130 is deposited. Thereafter, the gate insulating layer 130 and the drain electrode DE (or source electrode SE) can be sequentially stacked on the second capacitor electrode CstE2 of the capacitor Cst. In this case, a seam SM can be generated in the gate insulating layer 130 and the drain electrode DE (or source electrode SE) by the foreign substances PT.

Then, the first insulating layer 140 can be formed on the drain electrode DE (or source electrode SE). A photoresist pattern PR can be formed on the first insulating layer 140 to expose a region where the first contact hole CH1 is to be formed, and the first insulating layer 140 provided in a region which is not covered by the photoresist pattern PR can be removed using an etchant. In this case, the etchant can permeate into the seam SM area generated by the foreign substances PT. Accordingly, the second capacitor electrode CstE2 of the capacitor Cst and the gate insulating layer 130 provided under the drain electrode DE (or source electrode SE) can also be etched by the etchant. While the drain electrode DE (or source electrode SE) is torn-off, a portion of the second capacitor electrode CstE2 of the capacitor Cst can be exposed through the first contact hole CH1.

Then, the anode connection line ACL can be formed on the first insulating layer 140. In this case, the anode connection line ACL can be electrically connected to the drain electrode DE (or source electrode SE) of the driving transistor DT through the first contact hole C1. In addition, the anode connection line ACL can also be in contact with a portion of the second capacitor electrode CstE2 of the capacitor Cst exposed through the first contact hole CH1, whereby the anode connection line ACL can also be electrically connected to the second capacitor electrode CstE2 of the capacitor Cst. The anode connection line ACL can be simultaneously connected to the drain electrode DE (or source electrode SE) of the driving transistor DT and the second capacitor electrode CstE2 of the capacitor Cst, whereby a defect such as a bright spot can occur.

In the transparent display panel 110 according to another example embodiment of the present disclosure, the first contact hole CH1 is disposed not to overlap the active layer ACT of the driving transistor DT and the second capacitor electrode CstE2 of the capacitor Cst, so that it is possible to prevent the other electrode other than the drain electrode DE (or source electrode SE) of the driving transistor DT from being exposed in the first contact hole CH1. Furthermore, the transparent display panel 110 according to another example embodiment of the present disclosure can prevent or reduce a short defect between the anode connection line ACL and the active layer ACT of the driving transistor DT or between the anode connection line ACL and the second capacitor electrode CstE2 of the capacitor Cst.

In the present disclosure, the divided first anode electrode and the second anode electrode included in one subpixel can be disposed adjacent to each other in the first direction between the transmissive areas disposed adjacent to each other in the first direction. In the present disclosure, as only one subpixel is disposed within the separation width of the transmissive areas disposed adjacent to each other, the width of the subpixels in the first direction increases, whereby a viewing angle can increase.

Also, in the present disclosure, the area of the transmissive area can be increased and the light transmittance can be improved.

Also, in the present disclose, the anode connection line can extend in the first direction between the transmissive areas disposed adjacent to the first direction according to the arrangement direction of the first anode electrode and the second anode electrode. In the disclosure, the first anode connection line for connecting the first anode electrode and the driving transistor and the second anode connection line for connecting the second anode electrode and the driving transistor can form the cutting areas in the different transmissive areas. That is, in the present disclosure, since the separation distance between the first cutting area of the first anode connection line for repairing the first anode electrode and the second cutting area of the second anode connection line for repairing the second anode electrode is large, even if laser is irradiated at the sufficient energy level for each of the first cutting area of the first anode connection line and the second cutting area of the second anode connection line, the cathode electrode and the encapsulation layer cannot be damaged.

Also, in the present disclosure the anode connection line can be formed on a layer different from the gate electrode, the source electrode, and the drain electrode of the driving transistor, the thickness of the anode connection line can be formed thinly. Accordingly, in the present disclosure, the cutting success rate for the anode connection line in the laser cutting process can be increased.

In addition, in the present disclosure, even if the low level of energy is used during the laser irradiation, the cutting can be well performed. Accordingly, in the present disclosure, the separation distance between the light emitting device and the cutting area provided in the first and second anode connection lines can be reduced and the separation distance between the plurality of cutting areas can be also reduced. In the present disclosure, the influence on elements disposed around the cutting area can be minimized even if the separation distance between the light emitting device and the cutting area provided in the first and second anode connection lines or the separation distance between the plurality of cutting areas is reduced.

In the disclosure, as the product defect rate decreases, manufacturing process costs can be reduced, manufacturing process time can be shortened, and production energy can be reduced. In addition, in the present disclosure, the generation of greenhouse gas which can occur due to the manufacturing process can be reduced, thereby implementing ESG (Environment/Social/Governance).

It will be apparent to those skilled in the art that various modifications and variations can be made in the present disclosure without departing from the scope of the disclosures. Thus, it is intended that the present disclosure covers the modifications and variations of this disclosure provided that within the scope of the claims.

## Claims

1. A transparent display device comprising:
a first substrate (111) including a first transmissive area (TA1) and a second transmissive area (TA2) for transmitting external light, and a non-transmissive area (NTA) disposed between the first transmissive area (TA1) and the second transmissive area (TA2);
a driving transistor (DT) provided in the non-transmissive area (NTA) on the first substrate (111);
an anode connection line (ACL) electrically connected to the driving transistor (DT); and
a light emitting device (ED) disposed on the driving transistor (DT) in the non-transmissive area (NTA), the light emitting device (ED) includes an anode electrode (E1) including a first anode electrode (E11) and a second anode electrode (E12), an emission layer (EL), and a cathode electrode (E2) ,
wherein the first transmissive area (TA1) and the second transmissive area (TA2) are spaced apart from each other in a first direction,
wherein the first anode electrode (E11) and the second anode electrode (E12) are disposed to be adjacent to each other in the first direction between the first transmissive area (TA1) and the second transmissive area (TA2), and
wherein the anode connection line (ACL) extends across the non-transmissive area (NTA) from the first transmissive area (TA1) to the second transmissive area (TA2).

2. The transparent display device according to claim 1, wherein the driving transistor (DT) includes an active layer, a gate electrode, a source electrode, and a drain electrode, and
wherein the anode connection line (ACL) is formed of a material whose oxidation degree is lower than an oxidation degree of a material of each of the gate electrode, the source electrode, and the drain electrode of the driving transistor.

3. The transparent display device according to claim 1 or 2, wherein only one pixel is disposed between the first transmissive area (TA1) and the second transmissive area (TA2).

4. The transparent display device according to any one of the preceding claims,
wherein the anode connection line (ACL) is electrically connected to the driving transistor (DT) through a first contact hole (CH1), and
wherein the anode connection line (ACL) includes a first anode connection line (ACL1) extending from the first contact hole (CH1) toward the first transmissive area (TA1) and connected to the first anode electrode (E11) at its one end, and a second anode connection line (AC12) extending from the first contact hole (CH1) toward the second transmissive area (TA2) and connected to the second anode electrode (E12) at its one end,
preferably the first anode connection line (ACL1) is electrically connected to the first anode electrode (E11) through a second contact hole (CH2) at its one end, and the second anode connection line (ACL2) is electrically connected to the second anode electrode (E12) through a third contact hole (CH3) at its one end.

5. The transparent display device according to claim 4, wherein the driving transistor (DT) is disposed between the second contact hole (CH2) and the third contact hole (CH3).

6. The transparent display device according to any one of the preceding claims 4-5, wherein the first anode connection line (ACL1) and the second anode connection line (ACL2) are disposed on the same layer and/or at least a portion of the first anode connection line (ACL1) overlaps the first anode electrode(E11) between the first transmissive area (TA1) and the driving transistor (DT), and at least a portion of the second anode connection line (ACl2) overlaps the second anode electrode (E12) between the second transmissive area (TA2) and the driving transistor (DT).

7. The transparent display device according any one of the preceding claims 4-6, wherein the first anode connection line (ACL1) is provided with a first cutting area (CTA1) in a region being not overlapped with the first anode electrode (E11) and the second anode connection line (ACL2) is provided with a second cutting area (CTA2) in a region being not overlapped with the second anode electrode (E12),
preferably the first cutting area (CTA1) is cut by using laser when a defect occurs in the first anode electrode (E11), and the second cutting area (CTA2) is cut by using laser when a defect occurs in the second anode electrode (E12).

8. The transparent display device according to claim 7, wherein the first anode connection line (ACL1) has a plurality of first cutting areas (CTA1) and the second anode connection line (ACL2) has a plurality of second cutting areas (CTA2) and/or the first cutting area (CTA1) for the first anode connection line (E11) is disposed in the first transmissive area (TA1), and the second cutting area (CTA2) for the second anode connection line (ACL2) is disposed in the second transmissive area (TA2).

9. The transparent display device according to any one of the preceding claims, wherein the driving transistor (DT) includes an active layer (ACT), a gate electrode (GE), a source electrode (SE), and a drain electrode (DE), and the anode connection line (ACL) is electrically connected to one of the source electrode and the drain electrode of the driving transistor (DT) through a first contact hole (CH1), preferably the first contact hole (CH1) is not overlapped with the active layer (ACT) of the driving transistor (DT).

10. The transparent display device according to claim 9, further comprising a capacitor (Cst) including a first capacitor electrode (CstE1) provided on the same layer as the active layer (ACT) of the driving transistor (DT) and a second capacitor electrode (CstE2) provided on the same layer as the gate electrode (GE) of the driving transistor (DT),
wherein the first contact hole (CH1) is not overlapped with the first capacitor electrode (CstE1) of the capacitor (Cst).

11. The transparent display device according to claim 9 or 10, wherein a thickness of the anode connection line (ACL) is thinner than a thickness of each of the gate electrode (GE), the source electrode (SE), and the drain electrode (DE) of the driving transistor (DT).

12. The transparent display device according to any one of the preceding claims, wherein the anode connection line (ACL) includes molybdenum and titanium and/or the anode connection line (ACL) is disposed on the driving transistor (DT).

13. The transparent display device according to any one of the preceding claims, wherein the first anode electrode (E11) includes a first protrusion (E11a) protruding toward the first transmissive area (TA1), and the second anode electrode (E12) includes a second protrusion (E12a) protruding toward the second transmissive area (TA2), preferably the anode connection line (ACL) includes a first anode connection line (ACL1) connected to the first protrusion (E11a) of the first anode electrode (E11) through a second contact hole (CH2) and the second anode connection line (ACL2) connected to the second protrusion (E12a) of the second anode electrode (E12) through a third contact hole (CH3).

14. The transparent display device according to any one of the preceding claims, further comprising a plurality of signal lines (SL) extending in a second direction in the non-transmissive area (NTA), wherein the driving transistor (DT) is disposed between the plurality of signal lines (SL) in the non-transmissive area (NTA), preferably the plurality of signal lines (SL) include:
a plurality of data lines (DL) disposed on one side of the driving transistor (DT);
a power line (VDDL, VSSL) disposed on the other side of the driving transistor (DT; and
a reference line (RL) disposed on the other side of the driving transistor (DT).

## Patentansprüche

1. Transparente Anzeigevorrichtung, die umfasst:
ein erstes Substrat (111), das einen ersten durchlässigen Bereich (TA1) und einen zweiten durchlässigen Bereich (TA2) zum Durchlassen externen Lichts und einen nicht durchlässigen Bereich (NTA), der zwischen dem ersten durchlässigen Bereich (TA1) und dem zweiten durchlässigen Bereich (TA2) angeordnet ist, enthält;
einen Ansteuertransistor (DT), der in dem nicht durchlässigen Bereich (NTA) auf dem ersten Substrat (111) vorgesehen ist;
eine Anodenverbindungsleitung (ACL), die mit dem Ansteuertransistor (DT) elektrisch verbunden ist; und
eine lichtemittierende Vorrichtung (ED), die auf dem Ansteuertransistor (DT) in dem nicht durchlässigen Bereich (NTA) angeordnet ist, wobei die lichtemittierende Vorrichtung (ED) eine Anodenelektrode (E1), die eine erste Anodenelektrode (E11) und eine zweite Anodenelektrode (E12) enthält, eine Emissionsschicht (EL) und eine Kathodenelektrode (E2) enthält,
wobei der erste durchlässige Bereich (TA1) und der zweite durchlässige Bereich (TA2) in einer ersten Richtung voneinander beabstandet sind,
wobei die erste Anodenelektrode (E11) und die zweite Anodenelektrode (E12) so angeordnet sind, dass sie in der ersten Richtung zwischen dem ersten durchlässigen Bereich (TA1) und dem zweiten durchlässigen Bereich (TA2) zueinander benachbart sind, und
wobei sich die Anodenverbindungsleitung (ACL) von dem ersten durchlässigen Bereich (TA1) über den nicht durchlässigen Bereich (NTA) zu dem zweiten durchlässigen Bereich (TA2) erstreckt.

2. Transparente Anzeigevorrichtung nach Anspruch 1, wobei der Ansteuertransistor (DT) eine aktive Schicht, eine Gate-Elektrode, eine Source-Elektrode und eine Drain-Elektrode enthält und
wobei die Anodenverbindungsleitung (ACL) aus einem Material gebildet ist, dessen Oxidationsgrad niedriger als ein Oxidationsgrad eines Materials jeder der Gate-Elektrode, der Source-Elektrode und der Drain-Elektrode des Ansteuertransistors ist.

3. Transparente Anzeigevorrichtung nach Anspruch 1 oder 2, wobei zwischen dem ersten durchlässigen Bereich (TA1) und dem zweiten durchlässigen Bereich (TA2) nur ein Pixel angeordnet ist.

4. Transparente Anzeigevorrichtung nach einem der vorhergehenden Ansprüche,
wobei die Anodenverbindungsleitung (ACL) mit dem Ansteuertransistor (DT) durch ein erstes Kontaktloch (CH1) elektrisch verbunden ist und
wobei die Anodenverbindungsleitung (ACL) eine erste Anodenverbindungsleitung (ACL1), die sich von dem ersten Kontaktloch (CH1) in Richtung des ersten durchlässigen Bereichs (TA1) erstreckt und mit der ersten Anodenelektrode (E11) an ihrem einen Ende verbunden ist, und eine zweite Anodenverbindungsleitung (AC12), die sich von dem ersten Kontaktloch (CH1) in Richtung des zweiten durchlässigen Bereichs (TA2) erstreckt und mit der zweiten Anodenelektrode (E12) an ihrem einen Ende verbunden ist, enthält,
wobei die erste Anodenverbindungsleitung (ACL1) vorzugsweise mit der ersten Anodenelektrode (E11) durch ein zweites Kontaktloch (CH2) an ihrem einen Ende verbunden ist und die zweite Anodenverbindungsleitung (ACL2) mit der zweiten Anodenelektrode (E12) durch ein drittes Kontaktloch (CH3) an ihrem einen Ende verbunden ist.

5. Transparente Anzeigevorrichtung nach Anspruch 4, wobei der Ansteuertransistor (DT) zwischen dem zweiten Kontaktloch (CH2) und dem dritten Kontaktloch (CH3) angeordnet ist.

6. Transparente Anzeigevorrichtung nach einem der vorhergehenden Ansprüche 4-5, wobei die erste Anodenverbindungsleitung (ACL1) und die zweite Anodenverbindungsleitung (ACL2) auf derselben Schicht angeordnet sind und/oder mindestens ein Abschnitt der ersten Anodenverbindungsleitung (ACL1) die erste Anodenelektrode (E11) zwischen dem ersten durchlässigen Bereich (TA1) und dem Ansteuertransistor (DT) überdeckt und mindestens ein Teil der zweiten Anodenverbindungsleitung (AC12) die zweite Anodenelektrode (E12) zwischen dem zweiten durchlässigen Bereich (TA2) und dem Ansteuertransistor (DT) überdeckt.

7. Transparente Anzeigevorrichtung nach einem der vorhergehenden Ansprüche 4-6, wobei die erste Anodenverbindungsleitung (ACL1) mit einem ersten Schnittbereich (CTA1) in einem Bereich, der nicht durch die erste Anodenelektrode (E11) überdeckt wird, versehen ist und die zweite Anodenverbindungsleitung (ACL2) mit einem zweiten Schnittbereich (CTA2) in einem Bereich, der nicht durch die zweite Anodenelektrode (E12) überdeckt wird, versehen ist,
wobei vorzugsweise der erste Schnittbereich (CTA1) durch Verwenden eines Lasers geschnitten wird, wenn ein Fehler in der ersten Anodenelektrode (E11) auftritt, und der zweite Schnittbereich (CTA2) durch Verwenden eines Lasers geschnitten wird, wenn ein Fehler in der zweiten Anodenelektrode (E12) auftritt.

8. Transparente Anzeigevorrichtung nach Anspruch 7, wobei die erste Anodenverbindungsleitung (ACL1) mehrere erste Schnittbereiche (CTA1) besitzt und die zweite Anodenverbindungsleitung (ACL2) mehrere zweite Schnittbereiche (CTA2) besitzt und/oder der erste Schnittbereich (CTA1) für die erste Anodenverbindungsleitung (E11) in dem ersten durchlässigen Bereich (TA1) angeordnet ist und der zweite Schnittbereich (CTA2) für die zweite Anodenverbindungsleitung (ACL2) in dem zweiten durchlässigen Bereich (TA2) angeordnet ist.

9. Transparente Anzeigevorrichtung nach einem der vorhergehenden Ansprüche, wobei der Ansteuertransistor (DT) eine aktive Schicht (ACT), eine Gate-Elektrode (GE), eine Source-Elektrode (SE) und eine Drain-Elektrode (DE) enthält und die Anodenverbindungsleitung (ACL) mit einer der Source-Elektrode und der Drain-Elektrode des Ansteuertransistors (DT) durch ein erstes Kontaktloch elektrisch verbunden ist, wobei das erste Kontaktloch (CH1) vorzugsweise nicht durch die aktive Schicht (ACT) des Ansteuertransistors (DT) überdeckt wird.

10. Transparente Anzeigevorrichtung nach Anspruch 9, die ferner einen Kondensator (Cst) umfasst, der eine erste Kondensatorelektrode (CstE1), die auf derselben Schicht wie die aktive Schicht (ACT) des Ansteuertransistors (DT) vorgesehen ist, und eine zweite Kondensatorelektrode (CstE2), die auf derselben Schicht wie die Gate-Elektrode (GE) des Ansteuertransistors (DT) vorgesehen ist, enthält,
wobei das erste Kontaktloch (CH1) nicht durch die erste Kondensatorelektrode (CstE1) des Kondensators (Cst) überdeckt wird.

11. Transparente Anzeigevorrichtung nach Anspruch 9 oder 10, wobei eine Dicke der Anodenverbindungsleitung (ACL) geringer als eine Dicke jeder der Gate-Elektrode (GE), der Source-Elektrode (SE) und der Drain-Elektrode (DE) des Ansteuertransistors (DT) ist.

12. Transparente Anzeigevorrichtung nach einem der vorhergehenden Ansprüche, wobei die Anodenverbindungsleitung (ACL) Molybdän und Titan enthält und/oder die Anodenverbindungsleitung (ACL) auf dem Ansteuertransistor (DT) angeordnet ist.

13. Transparente Anzeigevorrichtung nach einem der vorhergehenden Ansprüche, wobei die erste Anodenelektrode (E11) einen ersten Vorsprung (E11a) enthält, der in Richtung des ersten durchlässigen Bereichs (TA1) vorsteht, und die zweite Anodenelektrode (E12) einen zweiten Vorsprung (E12a) enthält, der in Richtung des zweiten durchlässigen Bereichs (TA2) vorsteht, wobei die Anodenverbindungsleitung (ACL) vorzugsweise eine erste Anodenverbindungsleitung (ACL1), die mit dem ersten Vorsprung (E11a) der ersten Anodenelektrode (E11) durch ein zweites Kontaktloch (CH2) verbunden ist, und die zweite Anodenverbindungsleitung (ACL2), die mit dem zweiten Vorsprung (E12a) der zweiten Anodenelektrode (E12) durch ein drittes Kontaktloch (CH3) verbunden ist, enthält.

14. Transparente Anzeigevorrichtung nach einem der vorhergehenden Ansprüche, die ferner mehrere Signalleitungen (SL) umfasst, die sich in einer zweiten Richtung in dem nicht durchlässigen Bereich (NTA) erstrecken, wobei der Ansteuertransistor (DT) zwischen den mehreren Signalleitungen (SL) in dem nicht durchlässigen Bereich (NTA) angeordnet ist, wobei die mehreren Signalleitungen (SL) vorzugsweise enthalten:
mehrere Datenleitungen (DL), die auf einer Seite des Ansteuertransistors (DT) angeordnet sind;
eine Stromleitung (VDDL, VSSL), die auf der anderen Seite des Ansteuertransistors (DT) angeordnet ist; und
eine Referenzleitung (RL), die auf der anderen Seite des Ansteuertransistors (DT) angeordnet ist.

## Revendications

1. Dispositif d'affichage transparent comportant :
un premier substrat (111) incluant une première zone transmissive (TA1) et une seconde zone transmissive (TA2) pour transmettre de la lumière externe, et une zone non transmissive (NTA) disposée entre la première zone transmissive (TA1) et la seconde zone transmissive (TA2) ;
un transistor d'attaque (DT) prévu dans la zone non transmissive (NTA) sur le premier substrat (111) ;
une ligne de connexion d'anode (ACL) électriquement connectée au transistor d'attaque (DT) ; et
un dispositif électroluminescent (ED) disposé sur le transistor d'attaque (DT) dans la zone non transmissive (NTA), le dispositif électroluminescent (ED) incluant une électrode d'anode (E1) incluant une première électrode d'anode (E11) et une seconde électrode d'anode (E12), une couche d'émission (El) et une électrode de cathode (E2),
dans lequel la première zone transmissive (TA1) et la seconde zone transmissive (TA2) sont espacées l'une de l'autre dans une première direction,
dans lequel la première électrode d'anode (E11) et la seconde électrode d'anode (E12) sont disposées de manière à être adjacentes l'une à l'autre dans la première direction entre la première zone transmissive (TA1) et la seconde zone transmissive (TA2), et
dans lequel la ligne de connexion d'anode (ACL) s'étend à travers la zone non transmissive (NTA) de la première zone transmissive (TA1) à la seconde zone transmissive (TA2).

2. Dispositif d'affichage transparent selon la revendication 1, dans lequel le transistor d'attaque (DT) inclut une couche active, une électrode de grille, une électrode de source et une électrode de drain, et
dans lequel la ligne de connexion d'anode (ACL) est formée d'un matériau dont le degré d'oxydation est inférieur à un degré d'oxydation d'un matériau de chaque électrode parmi l'électrode de grille, l'électrode de source et l'électrode de drain du transistor d'attaque.

3. Dispositif d'affichage transparent selon la revendication 1 ou 2, dans lequel un seul pixel est disposé entre la première zone transmissive (TA1) et la seconde zone transmissive (TA2).

4. Dispositif d'affichage transparent selon l'une quelconque des revendications précédentes,
dans lequel la ligne de connexion d'anode (ACL) est électriquement connectée au transistor d'attaque (DT) par un premier trou de contact (CH1), et
dans lequel la ligne de connexion d'anode (ACL) inclut une première ligne de connexion d'anode (ACL1) s'étendant à partir du premier trou de contact (CH1) vers la première zone transmissive (TA1) et connectée à la première électrode d'anode (E11) à son extrémité, et une seconde ligne de connexion d'anode (ACL2) s'étendant à partir du premier trou de contact (CH1) vers la seconde zone transmissive (TA2) et connectée à la seconde électrode d'anode (E12) à son extrémité,
de préférence, la première ligne de connexion d'anode (ACL1) est électriquement connectée à la première électrode d'anode (E11) par un deuxième trou de contact (CH2) à une extrémité, et la seconde ligne de connexion d'anode (ACL2) est électriquement connectée à la seconde électrode d'anode (E12) par un troisième trou de contact (CH3) à son extrémité.

5. Dispositif d'affichage transparent selon la revendication 4, dans lequel le transistor d'attaque (DT) est disposé entre le deuxième trou de contact (CH2) et le troisième trou de contact (CH3).

6. Dispositif d'affichage transparent selon l'une quelconque des revendications 4 à 5 précédentes, dans lequel la première ligne de connexion d'anode (ACL1) et la seconde ligne de connexion d'anode (ACL2) sont disposées sur la même couche et/ou au moins une partie de la première ligne de connexion d'anode (ACL1) chevauche la première électrode d'anode (E11) entre la première zone transmissive (TA1) et le transistor d'attaque (DT), et au moins une partie de la seconde ligne de connexion d'anode (ACl2) chevauche la seconde électrode d'anode (E12) entre la seconde zone transmissive (TA2) et le transistor d'attaque (DT).

7. Dispositif d'affichage transparent selon l'une quelconque des revendications 4 à 6 précédentes, dans lequel la première ligne de connexion d'anode (ACL1) est pourvue d'une première zone de coupe (CTA1) dans une région qui n'est pas chevauchée par la première électrode d'anode (E11), et la seconde ligne de connexion d'anode (ACL2) est pourvue d'une seconde zone de coupe (CTA2) dans une région qui n'est pas chevauchée par la seconde électrode d'anode (E12),
de préférence, la première zone de coupe (CTA1) est découpée en utilisant un laser lorsqu'un défaut apparaît dans la première électrode d'anode (E11), et la seconde zone de coupe (CTA2) est découpée en utilisant un laser lorsqu'un défaut apparaît dans la seconde électrode d'anode (E12).

8. Dispositif d'affichage transparent selon la revendication 7, dans lequel la première ligne de connexion d'anode (ACL1) a une pluralité de premières zones de coupe (CTA1) et la seconde ligne de connexion d'anode (ACL2) a une pluralité de secondes zones de coupe (CTA2) et/ou la première zone de coupe (CTA1) pour la première ligne de connexion d'anode (E11) est disposée dans la première zone transmissive (TA1), et la seconde zone de coupe (CTA2) pour la seconde ligne de connexion d'anode (ACL2) est disposée dans la seconde zone transmissive (TA2).

9. Dispositif d'affichage transparent selon l'une quelconque des revendications précédentes, dans lequel le transistor d'attaque (DT) inclut une couche active (ACT), une électrode de grille (GE), une électrode de source (SE) et une électrode de drain (DE), et la ligne de connexion d'anode (ACL) est électriquement connectée à une électrode parmi l'électrode de source et l'électrode de drain du transistor d'attaque (DT) par un premier trou de contact (CH1), le premier trou de contact (CH1) n'étant pas, de préférence, chevauché par la couche active (ACT) du transistor d'attaque (DT).

10. Dispositif d'affichage transparent selon la revendication 9, comportant en outre un condensateur (Cst) incluant une première électrode de condensateur (CstE1) prévue sur la même couche que la couche active (ACT) du transistor d'attaque (DT), et une seconde électrode de condensateur (CstE2) prévue sur la même couche que l'électrode de grille (GE) du transistor d'attaque (DT),
dans lequel le premier trou de contact (CH1) n'est pas chevauché par la première électrode de condensateur (CstE1) du condensateur (Cst).

11. Dispositif d'affichage transparent selon la revendication 9 ou 10, dans lequel une épaisseur de la ligne de connexion d'anode (ACL) est plus mince qu'une épaisseur de chaque électrode parmi l'électrode de grille (GE), l'électrode de source (SE) et l'électrode de drain (DE) du transistor d'attaque (DT).

12. Dispositif d'affichage transparent selon l'une quelconque des revendications précédentes, dans lequel la ligne de connexion d'anode (ACL) inclut du molybdène et du titane et/ou la ligne de connexion d'anode (ACL) est disposée sur le transistor d'attaque (DT).

13. Dispositif d'affichage transparent selon l'une quelconque des revendications précédentes, dans lequel la première électrode d'anode (E11) inclut une première saillie (E11a) faisant saillie vers la première zone transmissive (TA1), et la seconde électrode d'anode (E12) inclut une seconde saillie (E12a) faisant saillie vers la seconde zone transmissive (TA2), la ligne de connexion d'anode (ACL) incluant de préférence une première ligne de connexion d'anode (ACL1) connectée à la première saillie (E11a) de la première électrode d'anode (E11) par un deuxième trou de contact (CH2) et la seconde ligne de connexion d'anode (ACL2) connectée à la seconde saillie (E12a) de la seconde électrode d'anode (E12) par un troisième trou de contact (CH3).

14. Dispositif d'affichage transparent selon l'une quelconque des revendications précédentes, comportant en outre une pluralité de lignes de signal (SL) s'étendant dans une seconde direction dans la zone non transmissive (NTA), dans lequel le transistor d'attaque (DT) est disposé entre la pluralité de lignes de signal (SL) dans la zone non transmissive (NTA), la pluralité de lignes de signal (SL) incluant de préférence :
une pluralité de lignes de données (DL) disposées sur un premier côté du transistor d'attaque (DT) ;
une ligne d'alimentation (VDDL, VSSL) disposée sur le second côté du transistor d'attaque (DT) ; et
une ligne de référence (RL) disposée sur le second côté du transistor d'attaque (DT).
